(19) **Europäisches Patentamt / European Patent Office / Office européen des brevets**

(11) **EP 4 447 536 A1**

(12) # EUROPEAN PATENT APPLICATION
published in accordance with Art. 153(4) EPC

(43) Date of publication:
**16.10.2024 Bulletin 2024/42**

(21) Application number: **22914204.7**

(22) Date of filing: **12.12.2022**

(51) International Patent Classification (IPC):
**H04W 28/02** $^{(2009.01)}$

(52) Cooperative Patent Classification (CPC):
**H04W 28/02; H04W 72/1263; H04W 72/23**

(86) International application number:
**PCT/CN2022/138463**

(87) International publication number:
**WO 2023/124949 (06.07.2023 Gazette 2023/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.12.2021 CN 202111679685**

(71) Applicant: **Huawei Technologies Co., Ltd.**
**Shenzhen, Guangdong 518129 (CN)**

(72) Inventors:
• **GAO, Xiang**
  **Shenzhen, Guangdong 518129 (CN)**
• **LIU, Kunpeng**
  **Shenzhen, Guangdong 518129 (CN)**
• **GONG, Mingxin**
  **Shenzhen, Guangdong 518129 (CN)**

(74) Representative: **Epping - Hermann - Fischer**
**Patentanwaltsgesellschaft mbH**
**Schloßschmidstraße 5**
**80639 München (DE)**

(54) **COMMUNICATION METHOD AND RELATED APPARATUS**

(57)     Embodiments of this application disclose a communication method and a related apparatus. The method includes: receiving downlink data from a network device, where the downlink data corresponds to one or more code blocks CBs; determining, based on the downlink data, a decoded sequence obtained by performing channel decoding on the downlink data, where the decoded sequence is an estimation result of the CB, and one decoded sequence corresponds to one CB; and sending indication information to the network device, where the indication information indicates first information, the first information is determined based on a quantity of non-zero elements or a quantity of zero elements included in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB. According to the solution of this application, CQI adjustment efficiency can be improved, thereby assisting the network device in better selecting an appropriate configuration parameter for downlink transmission for a terminal device.

FIG. 3

## Description

This application claims priority to Chinese Patent Application No. 202111679685.3, filed with the China National Intellectual Property Administration on December 31, 2021 and entitled "COMMUNICATION METHOD AND RELATED APPARATUS", which is incorporated herein by reference in its entirety.

## TECHNICAL FIELD

Embodiments of this application relate to the wireless communication field, and in particular, to a communication method and a related apparatus.

## BACKGROUND

A multiple-input and multiple-output (multiple-input and multiple-output, MIMO) technology is a core technology of a long term evolution (long term evolution, LTE) system and 5G new radio (new radio, NR). In a MIMO communication system, a base station may obtain channel quality of a downlink channel based on channel quality indicator (channel quality indication, CQI) information sent by a terminal device, to select an appropriate modulation and coding scheme (modulation and coding scheme, MCS) for the terminal device, thereby maximizing utilization of a channel capability and improving a throughput rate of the communication system.

Usually, the terminal device measures the downlink channel based on a downlink channel state information reference signal (channel state information reference signal, CSI-RS), to determine the CQI information. A CQI may be considered as a quantized result of a signal to interference plus noise ratio (signal to interference plus noise ratio, SINR) on a receiving side. The CQI needs to be calculated based on assumptions of many parameters such as a rank (rank) and a precoding matrix indicator (precoding matrix index, PMI). In addition, to ensure that a network device and the terminal device can align CQI measurement assumptions, a plurality of assumptions for measuring the CQI by the terminal device are defined in a protocol. There may be a specific difference between such an assumed case and an actual transmission case corresponding to an actual downlink scheduling moment, which causes a problem that the CQI is inaccurately calculated.

To resolve a problem that a CQI reported by the terminal device is different from (or in other words, is not close to, does not match, or has a large difference from) a CQI of an actual downlink channel, a person skilled in the art proposes an outer loop link adaptation (outer loop link adaptation, OLLA) technology. Because there is a mapping relationship between the SINR and the CQI, in the OLLA, the network device adjusts the SINR depending on whether a downlink transmitted data block is correctly decoded, for example, increases or decreases the SINR/CQI based on acknowledgment character (acknowledgment character, ACK)/negative acknowledgment character (negative acknowledgment character, NACK) feedback corresponding to a previously transmitted data block. Usually, it takes a long time to match the reported CQI with a CQI corresponding to an actual transmission link through the OLLA, especially when an estimated SINR differs greatly from an actual SINR. In addition, this manner is sensitive to an error. Once an error occurs, an adjustment process is significantly affected, and time required for the adjustment is greatly prolonged.

## SUMMARY

Embodiments of this application provide a communication method and apparatus, to provide a more accurate CQI based on a data channel/signal decoding result. The CQI can better reflect detection and decoding capabilities of a data channel/signal, thereby improving CQI adjustment efficiency, and further assisting a network device in better selecting an appropriate configuration parameter for downlink transmission for a terminal device.

According to a first aspect, this application provides a communication method. The method includes: receiving downlink data from a network device, where the downlink data corresponds to one or more code blocks CBs; determining, based on the downlink data, a decoded sequence obtained by performing channel decoding on the downlink data, where the decoded sequence is an estimation result of the CB, and one decoded sequence corresponds to one CB; and sending indication information to the network device, where the indication information indicates first information, the first information is determined based on a quantity of non-zero elements or a quantity of zero elements included in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB.

According to the method, CQI adjustment efficiency can be improved, thereby assisting the network device in better selecting an appropriate configuration parameter for downlink transmission for the terminal device. For example, the configuration parameter for the downlink transmission includes one or more of the following: a rank rank, a modulation and coding scheme MCS (including a modulation scheme and/or an adjustment order), a transport block size (TB size),

and a channel coding code rate.

Optionally, the decoded sequence may alternatively be an estimation result of an information sequence corresponding to the code block, or may be an estimation result of an encoded sequence corresponding to the code block. The information sequence corresponding to the code block may alternatively be referred to as an unencoded sequence corresponding to the code block. For binary channel coding, the information sequence corresponding to the code block may alternatively be referred to as information corresponding to the code block, or an unencoded bit sequence corresponding to the code block. The encoded sequence corresponding to the code block may alternatively be referred to as an encoded bit sequence corresponding to the code block.

With reference to the first aspect, in a possible implementation, the first information is at least one of the following information: a quantity of non-zero elements included in first data corresponding to at least one of the one or more CBs, a proportion of a non-zero element included in first data corresponding to at least one of the one or more CBs, an average value of quantities of non-zero elements included in first data corresponding to at least one of the one or more CBs, a sum of quantities of non-zero elements included in first data corresponding to at least one of the one or more CBs, an average value of proportions of non-zero elements included in first data corresponding to at least one of the one or more CBs, a block error rate BLER corresponding to the at least one of the one or more CBs, or a BLER corresponding to a CB set including the plurality of CBs. It should be noted that the BLER corresponding to the CB or the BLER corresponding to the CB set may alternatively be another statistical form indicating an error rate, for example, a bit error rate (bit error rate, BER) or a frame error rate (or referred to as a frame error rate) (frame error rate, FER).

Optionally, the first information may alternatively be at least one of the following information: a maximum value of quantities of non-zero elements included in first data corresponding to at least one of the one or more CBs, a minimum value of quantities of non-zero elements included in first data corresponding to at least one of the one or more CBs, a maximum value of proportions of non-zero elements included in first data corresponding to at least one of the one or more CBs, or a minimum value of proportions of non-zero elements included in first data corresponding to at least one of the one or more CBs.

With reference to the first aspect, in a possible implementation, the first information is at least one of the following information: a quantity of zero elements included in first data corresponding to at least one of the one or more CBs, a proportion of a zero element included in first data corresponding to at least one of the one or more CBs, an average value of quantities of zero elements included in first data corresponding to at least one of the one or more CBs, a sum of quantities of zero elements included in first data corresponding to at least one of the one or more CBs, or an average value of proportions of zero elements included in first data corresponding to at least one of the one or more CBs.

Optionally, the first information may alternatively be at least one of the following information: a maximum value of quantities of zero elements included in first data corresponding to at least one of the one or more CBs, a minimum value of quantities of zero elements included in first data corresponding to at least one of the one or more CBs, a maximum value of proportions of zero elements included in first data corresponding to at least one of the one or more CBs, or a minimum value of proportions of zero elements included in first data corresponding to at least one of the one or more CBs.

The first information in the foregoing implementation may be used to measure an error rate in a downlink data transmission process. In other words, a value of the first information is related to a value of the error rate. The error rate may reflect detection and decoding capabilities of a data channel/signal. The network device may adjust the CQI based on the first information, so that the network device can be assisted in better selecting the appropriate configuration parameter for the downlink transmission for the terminal device.

A case in which the first information is the quantity of the non-zero elements (or the zero elements) included in the first data corresponding to the at least one of the one or more CBs, or the proportion of the non-zero element (or the zero element) included in the first data corresponding to the at least one of the one or more CBs can reflect cases of a plurality of pieces of data, increase a quantity of reference bases for the network device to adjust the CQI, and assist the network device in better selecting the appropriate configuration parameter for the downlink transmission for the terminal device.

A case in which the first information is the average value of the quantities of the non-zero elements (or the zero elements) included in the first data corresponding to the at least one of the one or more CBs, the average value of the proportions of the non-zero elements (or the zero elements) included in the first data corresponding to the at least one of the one or more CBs, or the sum of the quantities of the non-zero elements (or the zero elements) included in the first data corresponding to the at least one of the one or more CBs can reflect an average status of data, reduce impact of a specific piece of erroneous data on accuracy of the indication information, reduce an information amount of the transmitted indication information, and reduce transmission overheads.

A case in which the first information is the block error rate BLER corresponding to the at least one of the one or more CBs, or the BLER corresponding to the CB set including the plurality of CBs can make reflected information direct, and increase a speed of determining the configuration parameter for the downlink transmission by the network device.

For a case in which the first information is the maximum value of the quantities of the non-zero elements (or the zero elements) included in the first data corresponding to the at least one of the one or more CBs, the minimum value of the quantities of the non-zero elements (or the zero elements) included in the first data corresponding to the at least one of the one or more CBs, the maximum value of the proportions of the non-zero elements (or the zero elements) included in the first data corresponding to the at least one of the one or more CBs, the minimum value of the proportions of the non-zero elements (or the zero elements) included in the first data corresponding to the at least one of the one or more CBs, the maximum value or the minimum value can reflect an upper bound or a lower bound of the error rate corresponding to the at least one of the plurality of CBs. Overall performance of a transmitted data block including the plurality of CBs is usually determined by a CB with worst transmission reliability or best transmission reliability. Therefore, the network device is enabled to learn of the overall performance of the transmitted data block including the plurality of CBs. This helps the network device obtain accurate actual downlink performance, and increases precision and the speed of determining the configuration parameter for the downlink transmission by the network device.

With reference to the first aspect, in a possible implementation, the first data is A, and $A = CH^T$, or $A = HC^T$. Optionally, the first data may alternatively be indicated by $CH^T$, $HC^T$, or another equivalent mathematical variation (for example, an operation like a transpose or a conjugate transpose), where $C$ is a vector of $1 \times (N - K)$, and $H$ is a matrix of $(N - K) \times N$. Alternatively, the first data may be in another mathematical representation form. For example, multiplication of a matrix may alternatively be indicated as multiplication of a vector, or multiplication and/or addition of a corresponding element, provided that a quantity of included non-zero elements or a quantity of zero elements is the same as the quantity of the non-zero elements or the quantity of the zero elements included in $CH^T$ or $HC^T$. These all fall within the protection scope of the present invention. When CB transmission is completely error free, a value of the first data in this implementation should be 0. Based on this principle, there is a correspondence between the quantity (or the proportion) of the non-zero elements/the non-zero element (or the zero elements/the zero element) included in the first data corresponding to the CB and the BLER corresponding to the CB.

With reference to the first aspect, in a possible implementation, the proportion of the non-zero element included in the first data is $\rho$, and $\rho = D(A)/(N - K)$, where $D(A)$ is the quantity of the non-zero elements, $N$ is a length of an encoded sequence corresponding to the CB, and $K$ is a length of an unencoded sequence corresponding to the CB. In this implementation, a manner of calculating the proportion of the non-zero element included in the first data is proposed.

With reference to the first aspect, in a possible implementation, the proportion of the zero element included in the first data is $R$, and $R = W(A)/(N - K)$, where $W(A)$ is the quantity of the zero elements included in the first data, $N$ is a length of an encoded sequence corresponding to the CB, and $K$ is a length of an unencoded sequence corresponding to the CB. In this implementation, a manner of calculating the proportion of the zero element included in the first data is proposed.

With reference to the first aspect, in a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

With reference to the first aspect, in a possible implementation, there is a correspondence between the BLER corresponding to the CB and the quantity of the zero elements included in the first data corresponding to the CB, or there is a correspondence between the BLER corresponding to the CB and the proportion of the zero element included in the first data corresponding to the CB. With reference to the first aspect, in a possible implementation, there is a correspondence between the error rate corresponding to the CB and the quantity of the non-zero elements (or the zero elements) included in the first data corresponding to the CB, or there is a correspondence between the error rate corresponding to the CB and the proportion of the non-zero element (or the zero element) included in the first data corresponding to the CB. The error rate corresponding to the CB may indicate a probability of correct or incorrect transmission of data information corresponding to the CB, and may be specifically the BLER, the bit error rate, the frame error rate, or the like.

Based on the correspondence in the foregoing implementation, the first information may be used to measure the error rate in the downlink data transmission process. With reference to the first aspect, in a possible implementation, the first information is the proportion of the non-zero element included in the first data, and the proportion of the non-zero element is one or more of a plurality of preset proportions.

With reference to the first aspect, in a possible implementation, the first information is the proportion of the zero element included in the first data, and the proportion of the zero element is one or more of a plurality of preset proportions.

Because a value of the preset proportion is fixed, a small quantity of bits may indicate the first information. In this manner, a length of the indication information can be reduced, and overheads can be reduced.

With reference to the first aspect, in a possible implementation, the plurality of preset proportions form an arithmetic sequence. Selection of the arithmetic sequence is simple. In addition, a plurality of possible preset proportions can be obtained by adjusting a common difference used by the arithmetic sequence. In actual application, an appropriate common difference may be selected based on an actual use scenario.

With reference to the first aspect, in a possible implementation, the downlink data is coded by using linear block code. For the linear block code, if a CB is correctly decoded, there is a relationship in which a product of a sequence that is obtained by performing channel decoding and that corresponds to the CB and a transposed matrix of a check matrix corresponding to the CB is zero. Based on this relationship, in an application scenario of the linear block code, there is the correspondence between the quantity (or the proportion) of the non-zero elements/the non-zero element (or the zero elements/the zero element) included in the first data corresponding to the CB and the BLER corresponding to the CB.

With reference to the first aspect, in a possible implementation, the indication information is carried in a hybrid automatic repeat request HARQ; or the sending indication information to the network device includes: sending the indication information to the network device over a physical uplink control channel PUCCH or a physical uplink shared channel PUSCH. The indication information is quickly fed back to the network device by using the HARQ, and there is no need to wait for a channel state information (channel state information, CSI) measurement and feedback period, so that a CQI adjustment speed can be increased.

According to a second aspect, this application provides a communication method. The method includes: sending a downlink data signal to a terminal device, where the downlink data signal corresponds to one or more code blocks CBs; and receiving indication information from the terminal device, where the indication information indicates first information, the first information is determined based on a quantity of non-zero elements included in first data, one piece of first data corresponds to one CB, the first data is related to $C$ and $H$, $C$ is a decoded sequence obtained by performing channel decoding on downlink data, and $H$ is a check matrix corresponding to the CB.

With reference to the second aspect, in a possible implementation, the method further includes: determining, based on the indication information, a configuration parameter for downlink transmission corresponding to the terminal device, where the configuration parameter includes one or more of the following: a rank rank, a modulation and coding scheme MCS, a transport block size TB size, and a channel coding code rate.

In a possible implementation, the configuration parameter for the downlink transmission corresponding to the terminal device may be determined based on reported CSI information and the indication information. The reported CSI information may include one or more of a CQI, a PMI, an RI, and the like. Alternatively, the CQI may be another parameter that can indicate signal transmission quality, for example, an SINR, an SNR, an SLNR, or an MCS. The reported CSI information may be historically reported CSI information. In an implementation, the reported CSI information may be CSI information reported on a latest CSI reporting occasion before the indication information is received, or may be CSI information reported on a latest CSI reporting occasion before the indication information is sent. Alternatively, the reported CSI information may be CSI information reported on a latest CSI reporting occasion within a preset time window before the indication information is received, or CSI information reported on a latest CSI reporting occasion within a preset time window before the indication information is sent. For example, if a length of the time window is L time units, and a moment at which the indication information is received or the indication information is sent is t, the preset time window before the indication information is received or the preset time window before the indication information is sent is time units included in a moment [$t$ - $L$, $t$]. Alternatively, the reported CSI information may be CSI information that is reported at a preset moment before the indication information is received, or CSI information that is reported at a preset moment before the indication information is sent. For example, the reported CSI information is CSI information reported at a moment $t$ - $L$ before the indication information is received, or CSI information reported at a moment $t$ - $L$ before the indication information is sent.

With reference to the second aspect, in a possible implementation, the first information is one of the following information: a quantity of non-zero elements included in first data corresponding to each of the one or more CBs, a proportion of a non-zero element included in first data corresponding to each of the one or more CBs, an average value of quantities of non-zero elements included in first data corresponding to each of the one or more CBs, or an average value of proportions of non-zero elements included in first data corresponding to each of the one or more CBs, and a block error rate BLER corresponding to the one or more CBs.

Optionally, the first information may alternatively be at least one of the following information: a maximum value of quantities of non-zero elements included in first data corresponding to at least one of the one or more CBs, a minimum value of quantities of non-zero elements included in first data corresponding to at least one of the one or more CBs, a maximum value of proportions of non-zero elements included in first data corresponding to at least one of the one or more CBs, or a minimum value of proportions of non-zero elements included in first data corresponding to at least one of the one or more CBs.

With reference to the second aspect, in a possible implementation, the first information is at least one of the following information: a quantity of zero elements included in first data corresponding to at least one of the one or more CBs, a proportion of a zero element included in first data corresponding to at least one of the one or more CBs, an average value of quantities of zero elements included in first data corresponding to at least one of the one or more CBs, a sum of quantities of zero elements included in first data corresponding to at least one of the one or more CBs, or an average value of proportions of zero elements included in first data corresponding to at least one of the one or more CBs.

Optionally, the first information may alternatively be at least one of the following information: a maximum value of quantities of zero elements included in first data corresponding to at least one of the one or more CBs, a minimum value of quantities of zero elements included in first data corresponding to at least one of the one or more CBs, a maximum value of proportions of zero elements included in first data corresponding to at least one of the one or more CBs, or a minimum value of proportions of zero elements included in first data corresponding to at least one of the one or more CBs.

With reference to the second aspect, in a possible implementation, the first data is $A$, and $A = CH^T$, or $A = HC^T$.

With reference to the second aspect, in a possible implementation, the proportion of the non-zero element included in the first data is $\rho$, and $\rho = D(A)/(N - K)$, where $D(A)$ is the quantity of the non-zero elements included in the first data, $N$ is a length of an encoded sequence corresponding to the CB, and $K$ is a length of an unencoded sequence corresponding to the CB.

With reference to the second aspect, in a possible implementation, the proportion of the zero element included in the first data is $R$, and $R = W(A) / (N - K)$, where $W(A)$ is the quantity of the zero elements included in the first data, $N$ is a length of an encoded sequence corresponding to the CB, and $K$ is a length of an unencoded sequence corresponding to the CB.

With reference to the second aspect, in a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

With reference to the second aspect, in a possible implementation, there is a correspondence between the BLER corresponding to the CB and the quantity of the zero elements included in the first data corresponding to the CB, or there is a correspondence between the BLER corresponding to the CB and the proportion of the zero element included in the first data corresponding to the CB.

With reference to the second aspect, in a possible implementation, the first information is the proportion of the non-zero element included in the first data, and the proportion of the non-zero element is one or more of a plurality of preset proportions.

With reference to the second aspect, in a possible implementation, the first information is the proportion of the zero element included in the first data, and the proportion of the zero element is one or more of a plurality of preset proportions.

With reference to the second aspect, in a possible implementation, the plurality of preset proportions form an arithmetic sequence.

With reference to the second aspect, in a possible implementation, the downlink data is coded by using linear block code.

With reference to the second aspect, in a possible implementation, the indication information is carried in a hybrid automatic repeat request HARQ sent by the terminal device; or the receiving indication information from the terminal device includes: receiving the indication information from the terminal device over a physical uplink control channel PUCCH or a physical uplink shared channel PUSCH.

According to a third aspect, this application provides a communication apparatus. The communication apparatus includes a receiving module, a determining module, and a sending module; the receiving module is configured to receive downlink data from a network device, where the downlink data corresponds to one or more code blocks CBs; the determining module is configured to determine, based on the downlink data, a decoded sequence obtained by performing channel decoding on the downlink data, where the decoded sequence is an estimation result of the CB, and one decoded sequence corresponds to one CB; and the sending module is configured to send indication information to the network device, where the indication information indicates first information, the first information is determined based on a quantity of non-zero elements or a quantity of zero elements included in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB.

With reference to the third aspect, in a possible implementation, the first information is at least one of the following information: a quantity of non-zero elements included in first data corresponding to at least one of the one or more CBs, a proportion of a non-zero element included in first data corresponding to at least one of the one or more CBs, an average value of quantities of non-zero elements included in first data corresponding to at least one of the one or more CBs, a sum of quantities of non-zero elements included in first data corresponding to at least one of the one or more CBs, an average value of proportions of non-zero elements included in first data corresponding to at least one of the one or more CBs, a block error rate BLER corresponding to the at least one of the one or more CBs, or a BLER corresponding to a CB set including the plurality of CBs.

With reference to the third aspect, in a possible implementation, the first data is A, and $A = CH^T$, or $A = HC^T$.

With reference to the third aspect, in a possible implementation, the proportion of the non-zero element included in the first data is $\rho$, and $\rho = D(A)/(N-K)$, where $D(A)$ is the quantity of the non-zero elements included in the first data, $N$ is a length of an encoded sequence corresponding to the CB, and $K$ is a length of an unencoded sequence corresponding to the CB.

With reference to the third aspect, in a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

With reference to the third aspect, in a possible implementation, the first information is the proportion of the non-zero element included in the first data, and the proportion of the non-zero element is one or more of a plurality of preset proportions.

With reference to the third aspect, in a possible implementation, the plurality of preset proportions form an arithmetic sequence.

With reference to the third aspect, in a possible implementation, the downlink data is coded by using linear block code.

With reference to the third aspect, in a possible implementation, the indication information is carried in a hybrid automatic repeat request HARQ; or the sending module is further configured to send the indication information to the network device over a physical uplink control channel PUCCH or a physical uplink shared channel PUSCH.

According to a fourth aspect, this application provides a communication apparatus. The communication apparatus includes a sending module and a receiving module; the sending module is configured to send a downlink data signal to a terminal device, where the downlink data signal corresponds to one or more code blocks CBs; and the receiving module is configured to receive indication information from the terminal device, where the indication information indicates first information, the first information is determined based on a quantity of non-zero elements included in first data, one piece of first data corresponds to one CB, the first data is related to $C$ and $H$, $C$ is a decoded sequence obtained by performing channel decoding on downlink data, and $H$ is a check matrix corresponding to the CB.

With reference to the fourth aspect, in a possible implementation, the communication apparatus further includes a determining module, and the determining module is configured to determine, based on the indication information, a configuration parameter for downlink transmission corresponding to the terminal device, where the configuration parameter includes one or more of the following: a rank rank, a modulation and coding scheme MCS, and a transport block size TB size.

With reference to the fourth aspect, in a possible implementation, the first information is one of the following information: a quantity of non-zero elements included in first data corresponding to each of the one or more CBs, a proportion of a non-zero element included in first data corresponding to each of the one or more CBs, an average value of quantities of non-zero elements included in first data corresponding to each of the one or more CBs, or an average value of proportions of non-zero elements included in first data corresponding to each of the one or more CBs, and a block error rate BLER corresponding to the one or more CBs.

With reference to the fourth aspect, in a possible implementation, the first data is $A$, and $A = CH^T$, or $A = HC^T$.

With reference to the fourth aspect, in a possible implementation, the proportion of the non-zero element included in the first data is $\rho$, and $\rho = D(A)/(N-K)$, where $D(A)$ is the quantity of the non-zero elements included in the first data, $N$ is a length of an encoded sequence corresponding to the CB, and $K$ is a length of an unencoded sequence corresponding to the CB.

With reference to the fourth aspect, in a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

With reference to the fourth aspect, in a possible implementation, the first information is the proportion of the non-zero element included in the first data, and the proportion of the non-zero element is one or more of a plurality of preset proportions.

With reference to the fourth aspect, in a possible implementation, the plurality of preset proportions form an arithmetic sequence.

With reference to the fourth aspect, in a possible implementation, the downlink data is coded by using linear block code.

With reference to the fourth aspect, in a possible implementation, the indication information is carried in a hybrid automatic repeat request HARQ sent by the terminal device; or the receiving module is further configured to receive the indication information from the terminal device over a physical uplink control channel PUCCH or a physical uplink shared channel PUSCH.

According to a fifth aspect, this application provides a communication apparatus, including a processor. The processor is configured to invoke program code or instructions stored in a memory, to enable the communication apparatus to perform the method according to the first aspect or any possible implementation of the first aspect, or perform the method according to the second aspect or any possible implementation of the second aspect.

According to a sixth aspect, this application provides a communication apparatus. The communication apparatus includes a logic circuit and an input/output interface, the input/output interface is configured to input a downlink data signal from a network device, the input/output interface is further configured to output indication information to the network device, and logic circuit is configured to: process the downlink data signal, and perform the method according to the first aspect or any possible implementation of the first aspect.

According to a seventh aspect, this application provides a communication apparatus. The communication apparatus includes a logic circuit and an input/output interface, the input/output interface is configured to send a downlink data signal to a terminal device, the input/output interface is further configured to receive indication information from the terminal device, and the logic circuit is configured to perform the method according to the second aspect or any possible implementation of the second aspect.

According to an eighth aspect, this application provides a computer-readable storage medium. The computer-readable storage medium is configured to store instructions, and when the instructions are executed, the method according to the first aspect or any possible implementation of the first aspect, or the method according to the second aspect or any possible implementation of the second aspect is implemented.

According to a ninth aspect, this application provides a computer program product. The computer program product includes a computer program or instructions, and when the computer program or the instructions are run on a computer, the computer is enabled to perform the method according to the first aspect or any possible implementation of the first aspect, or perform the method according to the second aspect or any possible implementation of the second aspect.

According to a tenth aspect, this application provides a communication system. The communication system includes the communication apparatus according to the third aspect and the communication apparatus according to the fourth aspect.

According to the solution of this application, the terminal device receives the downlink data from the network device, and the downlink data corresponds to the one or more code blocks. The terminal device may observe, based on the received downlink data, an error rate representation (for example, the quantity of the non-zero elements included in the first data, the proportion of the non-zero element included in the first data, or the BLER corresponding to the CB) in an actual data transmission process, and send an observation result to the network device. The network device can adjust the CQI based on the observation result. The first data corresponds to the CB, the first data is related to $C$ and $H$, $C$ is the decoded sequence obtained by performing the channel decoding on the downlink data, and $H$ is the check matrix corresponding to the CB. In this manner, more detailed adjustment information can be provided for the network device, and the CQI adjustment efficiency can be improved, thereby assisting the network device in better selecting the appropriate configuration parameter (for example, the MCS or a downlink data block size) for the downlink transmission for the terminal device, optimizing a channel capability, and improving a throughput rate of the communication system.

## BRIEF DESCRIPTION OF DRAWINGS

To describe technical solutions in embodiments of this application or in the conventional technology more clearly, the following briefly describes accompanying drawings required used in describing embodiments or the conventional technology.

FIG. 1 is a diagram of a network architecture of a wireless communication system according to an embodiment of this application;
FIG. 2 is a diagram of an SINR adjusted through OLLA and an actual SINR at a receiving end according to an embodiment of this application;
FIG. 3 is a flowchart of a communication method according to an embodiment of this application;
FIG. 4 is a diagram of a structure of a communication apparatus according to an embodiment of this application;
FIG. 5 is a diagram of a structure of another communication apparatus according to an embodiment of this application;
FIG. 6 is a diagram of a structure of another communication apparatus according to an embodiment of this application; and
FIG. 7 is a diagram of a structure of a chip according to an embodiment of this application.

## DESCRIPTION OF EMBODIMENTS

The following describes technical solutions in embodiments of this application in more detail.

Terms used in the following embodiments of this application are merely intended to describe specific embodiments, but are not intended to limit this application. Terms "one", "a", "the", "the foregoing", "this", and "the one" of singular forms used in this specification and the appended claims of this application are also intended to include plural forms, unless otherwise specified in the context clearly. It should be further understood that a term "and/or" used in this application indicates and includes any or all possible combinations of one or more listed items. A term "a plurality of" used in this application means two or more.

It should be noted that in the specification, claims, and accompanying drawings of this application, terms "first", "second", "third", and the like are intended to distinguish between similar objects but do not necessarily indicate a specific order or sequence. It should be understood that the data termed in such a way is interchangeable in appropriate circumstances, so that embodiments of this application described herein can be implemented in an order other than the order illustrated or described herein. In addition, terms "include" and any other variants are intended to cover non-exclusive inclusion. For example, a process, method, system, product, or server that includes a list of steps or units is not necessarily limited to those expressly listed steps or units, but may include other steps or units not expressly listed or inherent to such a process, method, product, or device.

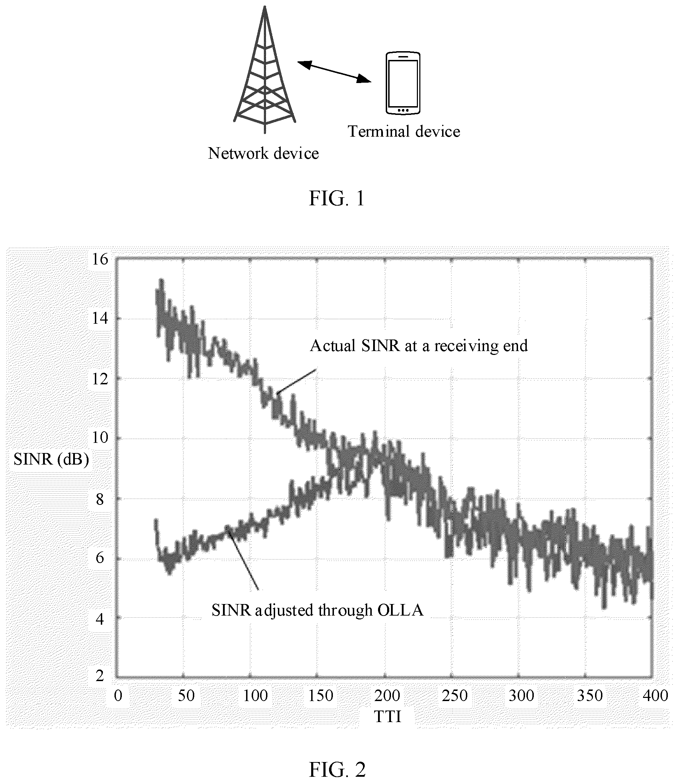

Embodiments of this application may be applied to a network architecture shown in FIG. 1. The network architecture shown in FIG. 1 is a network architecture of a wireless communication system. The network architecture usually includes a terminal device and a network device. A quantity and a form of each device constitute no limitation on embodiments of this application.

It should be noted that the wireless communication system mentioned in embodiments of this application includes but is not limited to an internet of things (internet of things, IoT) system, a long term evolution (long term evolution, LTE) system, a 5th generation (5th generation, 5G) mobile communication system, a 6th generation (6th generation, 6G) mobile communication system, and a future mobile communication system. In some embodiments, the technical solutions in embodiments of this application may be further applied to a wireless local area network (Wireless Local Area Network, WLAN) network, may be further applied to a vehicle-to-x (Vehicle-to-X, V2X) network, may be further applied to a non-terrestrial network (non-terrestrial network, NTN), a satellite and high-altitude platform (Satellite and High-Altitude Platform, HAP) network, an enhanced internet of things (LTE enhanced MTO, eMTC), and may be further applied to another network. In some other embodiments, the technical solutions in embodiments of this application may be further applied to a communication-radar integrated communication system, a terahertz communication system, a communication system with a higher frequency, and the like. This is not specifically limited in this application.

The network device in embodiments of this application may be a base station (Base Station, BS). The base station may provide communication services for a plurality of terminal devices, or a plurality of base stations may provide communication services for a same terminal device. In embodiments of this application, the base station is an apparatus deployed in a radio access network to provide a wireless communication function for a terminal device. The base station device may be a base station, a relay station, or an access point. The base station may be an eNB or an eNodeB (Evolved NodeB) in long term evolution (Long Term Evolution, LTE). Alternatively, the base station device may be a radio controller in a cloud radio access network (Cloud Radio Access Network, CRAN) scenario. Alternatively, the base station device may be a base station device in a future 6G network or a network device in a future evolved PLMN network. Alternatively, the base station device may be a wearable device, a vehicle-mounted device, or the like. In embodiments of this application, an apparatus configured to implement functions of a network device may be a network device, or may be an apparatus that can support the network device in implementing the functions, for example, a chip system. The apparatus may be installed in the network device. For example, the network device may be a central unit (central unit, CU), or may be a distributed unit (distributed unit, DU). The CU herein completes functions of a radio resource control protocol and a packet data convergence layer protocol (packet data convergence protocol, PDCP) of the base station, and may further complete a function of a service data adaptation protocol (service data adaptation protocol, SDAP). The DU completes functions of a radio link control layer and a medium access control (medium access control, MAC) layer of the base station, and may further complete a function of some or all physical layers. For specific descriptions of the protocol layers, refer to related technical specifications of a 3rd generation partnership project (3rd generation partnership project, 3GPP).

The terminal device in embodiments of this application may also be referred to as a terminal, and may be a device having a wireless transceiver function. The terminal device in embodiments of this application may include various user equipments (user equipment, UE) that have a wireless communication function, an access terminal, a UE unit, a UE station, a mobile station, a mobile console, a remote station, a remote terminal, a mobile device, a UE terminal, a terminal, a wireless communication device, a UE agent, or a UE apparatus. The access terminal may be a cellular phone, a cordless phone, a session initiation protocol (Session Initiation Protocol, SIP) phone, a wireless local loop (Wireless Local Loop, WLL) station, a personal digital assistant (Personal Digital Assistant, PDA), a handheld device having a wireless communication function, a computing device, another processing device connected to a wireless modem, an unmanned aerial vehicle (or drone for short) (unmanned aerial vehicle/drone, UVA), a vehicle-mounted device, a wearable device, a terminal device in a future 6G network, a terminal device in a future evolved PLMN network, or the like. In embodiments of this application, an apparatus configured to implement functions of a terminal may be a terminal, or may be an apparatus that can support the terminal in implementing the functions, for example, a chip system. The apparatus may be installed in the terminal. In embodiments of this application, the chip system may include a chip, or may include a chip and another discrete component.

Embodiments of this application may be applied to a device-to-device (device-to-device, D2D) system, a machine-to-machine (machine-to-machine, M2M) system, a vehicle-to-everything (vehicle-to-everything, V2X) system, or the like.

Embodiments of this application may be applied to a next-generation microwave scenario, an NR-based microwave scenario, an integrated access backhaul (integrated access backhaul, IAB) scenario, or the like.

In embodiments of this application, the network device and the terminal device may be fixed or movable. The network device and the terminal device may be deployed on the land, including an indoor device, an outdoor device, a handheld device, or a vehicle-mounted device; may be deployed on water; or may be deployed on an airplane, a balloon, and a satellite in the air. Application scenarios of the network device and the terminal device are not limited in embodiments of this application.

A network architecture and a service scenario described in embodiments of this application are intended to describe the technical solutions in embodiments of this application more clearly, and do not constitute a limitation on the technical solutions provided in embodiments of this application. A person of ordinary skill in the art may learn that, with evolution of the network architecture and emergence of new service scenarios, the technical solutions provided in embodiments of this application are also applicable to similar technical problems.

The following describes some concepts in embodiments of this application.

1. Block error rate (block error rate, BLER)

In a wireless communication network, a device (for example, an eNodeB) sends data to another device (for example, UE) by block (block). The sending end calculates a cyclic redundancy check (cyclic redundancy check, CRC) by using data in the block, and sends the cyclic redundancy check together with the block to the receiving end. The receiving end calculates a CRC based on received data, and compares the CRC with the received CRC. If the two CRCs are the same, the receiving end considers that correct data is successfully received, and returns an "ACK" to the sending end, or if the two CRCs are different, the receiving end considers that incorrect data is received, and returns an "NACK" to the sending end, to request the sending end to retransmit the block. If the sending end does not receive response from the receiving end within a specific period, the sending end assumes that the previously sent block does not arrive at the receiving end, and the sending end automatically retransmits the block. This mode is referred to as hybrid automatic repeat request (hybrid automatic repeat request, HARQ) processing at an MAC layer.

The block error rate is a percentage of an error block to all sent blocks (only initially transmitted blocks are counted). For example, in LTE, a target BLER of a control channel is 1%, and a target BLER of a data channel is 10%. In actual application, a BLER of a specific percentage (for example, the BLER of the data channel in LTE is required to be less than 10%) is not always necessary, because retransmission and special processing (for example, soft combination) can be performed on the error block, so that the receiving end correctly decodes the received data.

The BLER is described by using an example: It is assumed that data of 500 blocks is sent, ACKs are returned for 499 blocks, and an NACK is returned for one block. In this case, the BLER is 1/500=0.002* 100%=0.2% (it can be seen from this example that when the BLER is calculated, the ACK/NACK of the retransmitted block is not counted).

It should be noted that the block (Block) may be understood as a data sequence or a data bit set on which channel coding is completed once. The block may alternatively be understood as a data sequence or a data bit set included in a data packet. The block may alternatively be understood as a data sequence of a predefined length or a data bit set of a predefined size.

2. Channel state information reference signal (channel state information reference signal, CSI-RS)

The CSI-RS is a reference signal used for channel measurement. Different from a cell reference signal (cell reference signal, CRS) that needs to be omnidirectionally sent and a demodulation reference signal (demodulation reference signal, DM-RS) that is sent only during data transmission, the CSI-RS can provide a more effective possibility of obtaining channel state information (channel state information, CSI), and support more antenna ports.

The CSI-RS is mainly used for the following purposes: 1. Channel state information obtaining for scheduling, link adaptation, and MIMO-related transmission settings. 2. Used for beam management: Beamforming weights on a terminal device side and a base station side are obtained to support a beam management process. 3. Accurate time-frequency tracking: is implemented by setting a phase reference signal (tracking reference signal, TRS) in a system, and the TRS is a CSI-RS. 4. Used for mobility management: In a system, CSI-RS signals of a source cell and a neighboring cell are obtained and tracked, to complete a measurement requirement related to mobility management of the terminal device. 5. Used for rate matching: A function of rate matching at a resource element (resource element, RE) level of a data channel is completed by setting a zero-power CSI-RS signal.

3. Channel quality indicator (channel quality indication, CQI)

In a MIMO communication system, a base station may obtain channel quality of a downlink channel based on channel quality indicator (channel quality indication, CQI) information sent by a terminal device, to select an appropriate modulation and coding scheme (modulation and coding scheme, MCS) and a corresponding downlink data block size for the terminal device, thereby optimizing a channel capability and improving a throughput rate of the communication system.

Usually, the terminal device measures the downlink channel based on a configured CSI-RS, to determine the CQI information. The CQI may be considered as a quantized result of a signal to interference plus noise ratio (signal to interference plus noise ratio, SINR) on a receiving side. The LTE specification defines a CQI selection criterion, that is, a CQI value used to ensure that a BLER of a physical downlink shared channel (physical downlink shared channel, PDSCH) is less than 10%. It should be noted that in this application, terms "channel quality indicator (CQI)" and "signal to interference plus noise ratio (SINR)" are used. Because there is a mapping relationship between the SINR and the CQI, in this application, the SINR and the CQI may be understood as same (or referred to as equivalent) meanings.

Currently, for different frequency domain subbands, a manner of reporting a wideband CQI in combination with a subband differential CQI is used, and a CQI of an $s^{th}$ frequency domain subband may be shown in Formula 1-1:

$$\text{Subband CQI=Wideband CQI+Subband differential CQI} \qquad \text{Formula 1-1}$$

Each subband corresponds to one common CQI. For example, in Formula 1-1, the common CQI is the wideband CQI, and the subband differential CQI is a difference between the CQI of the $s^{th}$ frequency domain subband and the wideband CQI.

For the wideband CQI, 4 bits are used for quantization. A CQI index indicates the wideband CQI. Refer to Table 1. CQI indices and modulation and coding schemes corresponding to the CQI indices are described. The modulation and coding scheme includes a modulation scheme, a code rate, and efficiency.

**Table 1**

| CQI index (CQI index) | Modulation (modulation) scheme | Code rate* 1024 (code rate* 1024) | Efficiency (efficiency) |
|---|---|---|---|
| 0 | Out of range (out of range) | | |
| 1 | QPSK | 78 | 0.1523 |
| 2 | QPSK | 193 | 0.3770 |
| 3 | QPSK | 449 | 0.8770 |
| 4 | 16QAM | 378 | 1.4766 |
| 5 | 16QAM | 490 | 1.9141 |
| 6 | 16QAM | 616 | 2.4063 |
| 7 | 64QAM | 466 | 2.7305 |
| 8 | 64QAM | 567 | 3.3223 |
| 9 | 64QAM | 666 | 3.9023 |
| 10 | 64QAM | 772 | 4.5234 |
| 11 | 64QAM | 873 | 5.1152 |
| 12 | 256QAM | 711 | 5.5547 |
| 13 | 256QAM | 797 | 6.2266 |
| 14 | 256QAM | 885 | 6.9141 |
| 15 | 256QAM | 948 | 7.4063 |

For example, the CQI index reported by the terminal device is 3. The CQI index indicates that the terminal device expects that the modulation scheme of downlink data of a network device is quadrature phase shift keying (quadrature phase shift keying, QPSK), the code rate is 449/1024, and the efficiency is 0.8770.

There is a correspondence between the modulation scheme and a modulation order, and the modulation order may indicate a quantity of bits that can be carried in each modulation symbol. For example, a modulation order corresponding to QPSK is 2, a modulation order corresponding to 16 quadrature amplitude modulation (quadrature amplitude modulation, QAM) is 4, and a modulation order corresponding to 64QAM is 6. The code rate is a ratio of a quantity of information bits in a transport block to a total quantity of bits on a physical channel corresponding to the transport block, that is: Code rate=Quantity of the information bits in the transport block/Total quantity of the bits on the physical channel corresponding to the transport block=Quantity of the information bits in the transport block/(Total quantity of symbols on the physical channel corresponding to the transport block*Modulation order)=Efficiency/Modulation order. Total quantity of bits on the physical channel corresponding to the transport block=Total quantity of the symbols on the physical channel corresponding to the transport block*Modulation order, and efficiency=Quantity of the information bits in the transport block/Total quantity of the symbols on the physical channel corresponding to the transport block. Optionally, the code rate may alternatively be indicated as: Code rate=Length of an unencoded sequence corresponding to a CB/Length of an encoded sequence corresponding to the CB.

It can be learned that different values of the CQI index indicate different modulation schemes and code rates for downlink transmission. A larger CQI index indicates a higher modulation order or code rate used for the downlink transmission and higher efficiency. When same physical channel resources are occupied, a larger CQI index indicates a larger size of the transport block corresponding to the downlink transmission, and therefore a higher downlink peak throughput is provided.

For the subband differential CQI, 2 bits are used for quantization. Refer to Table 2. Subband differential CQI values and offset levels corresponding to the subband differential CQI values are described.

**Table 2**

| Subband differential CQI | CQI offset level |
| --- | --- |
| 0 | 0 |
| 1 | 1 |
| 2 | $\geq 2$ |
| 3 | $\leq 1$ |

The CQI plays a key role in downlink scheduling. The terminal device (for example, UE) estimates the CQI based on an SINR value, and reports the CQI in a periodic or aperiodic manner. The network device (for example, an eNodeB) extracts corresponding wideband or subband CQI information based on different CQI modes, and learns of an interference status of the UE on a specific frequency band, to implement frequency selective or non-selective scheduling. It is important that the eNodeB obtains MCS and transport block set (transport block set, TBS) information based on CQI and physical resource block (physical resource block, PRB) information. This directly affects the downlink throughput. In an implementation, there is a correspondence between a CQI index value and a specific modulation and coding scheme (MCS), or there is a correspondence between a CQI index value and a specific SINR value.

The CQI is related to a plurality of parameters in a data transmission process, and the network device needs to know a parameter based on which the terminal device calculates the CQI. Therefore, currently, the CQI needs to be calculated based on assumptions of many parameters such as a rank (rank) and a precoding matrix indicator (precoding matrix index, PMI). In addition, to ensure that a network device and the terminal device can align CQI measurement assumptions, a plurality of assumptions for measuring the CQI by the terminal device are defined in a protocol.

For example, these assumptions may include the following content:

(1) First two orthogonal frequency division multiplexing (orthogonal frequency division multiplexing, OFDM) symbols in one slot (slot) are occupied by a control signal.
(2) A quantity of symbols of a PDSCH and a quantity of symbols of a DM-RS are 12.
(3) PDSCH reception has a same bandwidth part (bandwidth part, BWP) subcarrier spacing.
(4) A bandwidth is the same as a corresponding CQI report (CQI report).
(5) A reference resource uses a cyclic prefix (cyclic prefix, CP) length and a subcarrier spacing that are the same as those of configured PDSCH reception.
(6) No resource element (resource element, RE) is used for a primary synchronization signal/secondary synchronization signal or a physical broadcast channel (physical broadcast channel, PBCH).
(7) Coding corresponds to a redundancy version 0.
(8) It is assumed that no RE is used to carry a non-zero power channel state information reference signal (non-zero power channel state information reference signal, NZP CSI-RS) and a zero power channel state information reference signal (zero power channel state information reference signal, ZP CSI-RS).

(9) It is assumed that a quantity of front-loaded DM-RS symbols is equal to a maximum quantity of front-loaded DM-RS symbols configured by a higher layer parameter maxLength.

(10) It is assumed that a quantity of additional DM-RS (additional DM-RS) symbols is equal to a quantity of additional DM-RS symbols configured by a higher layer parameter dmrs-AdditionalPosition.

(11) It is assumed that a PDSCH symbol does not include a DM-RS.

(12) It is assumed that a size of a PRB bundling (PRB bundling) is 2 PRBs.

There may be a specific difference between this assumed case and an actual transmission case corresponding to an actual downlink scheduling moment. For example, there may be a difference between a single-user MIMO and a multi-user MIMO in use scenarios, a difference in precoding matrices, a difference in receiver performance, a difference caused by a delay, and the like. Because the assumed case may be inconsistent with the actual case, and the CQI is still calculated based on the assumption, this calculation manner results in that the CQI is inaccurately calculated.

4. Outer loop link adaptation (outer loop link adaptation, OLLA)

To resolve a problem that a reported CQI is different from (or referred to as is not close to, does not match, or has a large difference from) a CQI of an actual downlink channel, a person skilled in the art proposes the OLLA. Because there is a mapping relationship between an SINR and a CQI, in the OLLA, a network device adjusts the SINR depending on whether a downlink transmitted data block is correctly decoded, for example, increases or decreases the SINR/CQI based on ACK)/NACK feedback corresponding to a previously transmitted data block. The SINR adjusted through the OLLA may be shown in Formula 1-2:

$$SINR = SINR_{SU-CQI} + \Delta_{OLLA} \qquad \text{Formula 1-2}$$

$SINR_{SU-CQI}$ is an SINR corresponding to the reported CQI. $\Delta_{OLLA}$ is an OLLA adjustment amount, indicates a small-amplitude adjustment value of the SINR, and may be usually a preset SINR adjustment step. For example, a preset target BLER is 0.1. When a previous downlink data block is correctly received (a terminal device feeds back an ACK), the network device increases the OLLA adjustment amount $\Delta_{OLLA}$, for example, $\Delta_{OLLA} = \Delta_{OLLA}+0.05$. When a previous downlink data block is not correctly received (the terminal device feeds back an NACK), the network device decreases the OLLA adjustment amount $\Delta_{OLLA}$, for example, $\Delta_{OLLA} = \Delta_{OLLA}-0.45$. It can be learned from the foregoing description of related content in Table 1 that the different values of the CQI index reported by the terminal device indicate the different modulation schemes and code rates that are expected by the terminal device for the downlink transmission. The OLLA technology is used, so that when the network device actually performs downlink transmission configuration, a CQI based on which the network device performs the downlink transmission configuration is not the CQI reported by the terminal device, but a CQI adjusted based on the reported CQI and the adjustment amount $\Delta_{OLLA}$. The adjusted CQI is closer to the actual CQI of the downlink channel.

Because small-step (or referred to as small-amplitude) adjustment is used in the OLLA, it takes a long time to match the reported CQI with a CQI corresponding to an actual link, especially when an estimated SINR differs greatly from an actual SINR, or when the reported CQI differs greatly from a CQI corresponding to actual link performance. FIG. 2 is a diagram of an SINR adjusted through OLLA and an actual SINR at a receiving end according to an embodiment of this application. As shown in FIG. 2, at an initial moment, a difference between a reported CQI and an SINR of an actual link is large (a difference of nearly 8 dB). In this case, the SINR can only be increased by 0.05 dB through the OLLA each time transmission is correct. Therefore, data transmission of nearly 150 transmission time intervals (transport time interval, TTI) is required to adjust an estimated value of the SINR to a value close to the SINR of the actual downlink. In addition, this manner is sensitive to an error. Once an error occurs, an adjustment process is significantly affected, and time required for the adjustment is greatly prolonged. When an actual data service is a burst short packet service, there are usually not many data sending opportunities. In this case, it is difficult to quickly converge to a target SINR through the OLLA SINR adjustment. Therefore, it is difficult for the current SINR to adapt to an actual channel condition, and MIMO transmission performance is poor. In view of this, the solutions in embodiments of this application are provided.

In embodiments of this application, a terminal device receives downlink data from a network device, where the downlink data corresponds to one or more code blocks (code block, CB). The terminal device may observe, based on the received downlink data, an error rate representation (for example, a quantity of non-zero elements included in first data, a proportion of a non-zero element included in first data, or a BLER corresponding to the CB) in an actual data transmission process, and send an observation result to the network device. The network device can adjust a CQI based on the observation result. One piece of first data corresponds to one CB, the first data is related to $C$ and $H$, $C$ is a decoded sequence obtained by performing channel decoding on the downlink data, and $H$ is a check matrix corresponding to the CB. Compared with an ACK/NACK transmission result, the error rate representation can provide more detailed adjustment information. In this way, CQI adjustment efficiency can be improved, thereby assisting the network device in better selecting an appropriate configuration parameter (for example, an MCS or a downlink data block size) for downlink transmission for the terminal device, optimizing a channel capability, and improving a throughput rate of a communication system.

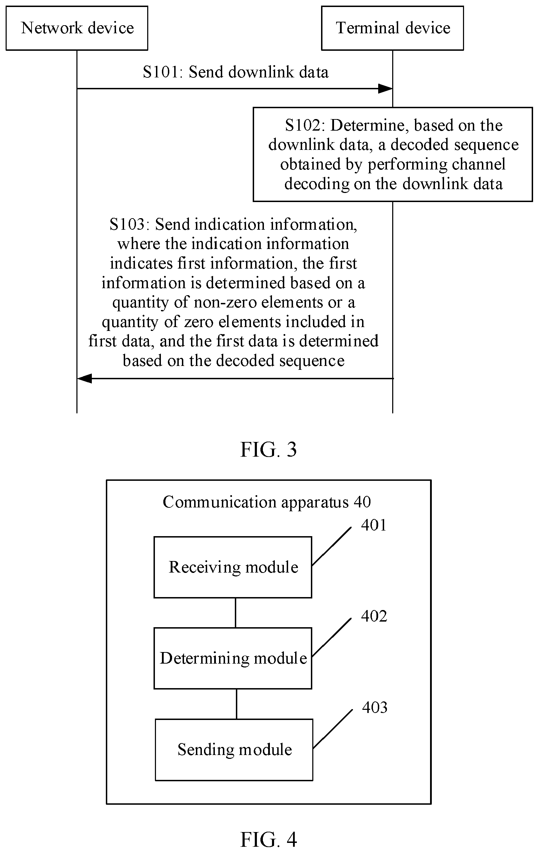

FIG. 3 is a flowchart of a communication method according to an embodiment of this application. The method may be implemented based on the system shown in FIG. 1. The method includes but is not limited to the following steps.

S101: The network device sends downlink data to the terminal device.

The downlink data may be transmitted in a form of a downlink data signal, and the downlink data signal may be carried over a downlink data channel (for example, a PDSCH). The downlink data corresponds to one or more CBs. In a transmission process, the network device sends the downlink data to the terminal device by block. The plurality of code blocks may be referred to as a code block group (CB group) or a code block set.

It should be noted that an MAC layer of a communication device (the network device or the terminal device) encapsulates data to obtain a transport block (transport block, TB), and then segments the TB based on a maximum code block length. A data block obtained through segmentation may be understood as the CB. Optionally, CRC processing may be further performed on the TB before the segmentation. In another implementation, the CB may alternatively be an entire data block including a plurality of data blocks obtained through the segmentation, and may also be referred to as the code block group (CB group, CB group) or the code block set. In addition, with evolution of communication technologies, there may be another manner of defining the CB. A definition of the CB is not limited in embodiments of this application.

For example, a downlink data transmission processing process is briefly described.

First, after encapsulating the downlink data, the MAC layer in the network device sends one or two transport blocks TBs to a downlink physical layer in a form of an MAC protocol data unit (protocol data unit, PDU).

Then, the downlink physical layer continues to process the received TB.

In a first step, the CRC processing is performed on the TB, and a CRC bit is added to an end of the TB. The receiving side is allowed to perform error detection on the TB during the CRC. If an error occurs during the CRC check, the TB may be retransmitted by using a HARQ, and a success rate of next decoding is improved through gain combining.

In a second step, a TB obtained through the CRC processing is segmented into M CBs, and then a CRC bit is added to an end of each CB. M is a positive integer greater than or equal to 1, and a value of M is related to a bit size of the TB (TB size). This step serves subsequent channel coding (for example, low-density parity-check (low-density parity-check code, LDPC) code). Current channel coding usually corresponds to the maximum code block length. When the maximum code block length is exceeded, code block segmentation needs to be performed. For example, an encoder can support a maximum code block size of 6144 bits, and the CRC bit is 24 bits. If (TBsize+24bitsCRC)<_8448 bits, M=1, indicating that there is only one CB block, the TB block does not need to be segmented, and no additional 24-bit CRC information needs to be added to the end of the CB block, and CRC information of the original TB block is directly used. If (TBsize+24bitsCRC)>8448 bits, the quantity of CBs M=ceil[(TBsize+24bitsCRC)/(8448-24)], where ceil is a rounding function, and the ceil function is used to return a minimum integer greater than or equal to the specified expression. In this case, an additional piece of 24-bit CRC information needs to be added to the end of each CB block. Content of the CRC is different from content of the CRC that is at the end of the TB block, and is used only for bit error detection of the CB block. For example, if TBsize=75376 bits, M=ceil[(75376+24)/(8448-24)]=9, that is, after this step, the downlink physical layer obtains nine CBs.

It should be noted that, it is considered that the TB block is correctly decoded only when all CBs are correctly decoded by the receiving end. If any CB block is incorrectly decoded, HARQ retransmission needs to be requested for the CB block, a CB group to which the CB block belongs, or a TB to which the CB block belongs. Content of the HARQ retransmission corresponds to content corresponding to ACK/NACK feedback. For example, if the ACK/NACK feedback is performed for the TB, the content of the HARQ retransmission corresponds to the TB. If the ACK/NACK feedback is performed for the CB, the content of the HARQ retransmission corresponds to the CB. If the ACK/NACK feedback is performed for the CB group, the content of the HARQ retransmission corresponds to the CB group. One TB includes one or more CB groups, and one CB group includes one or more CBs.

In a third step, channel coding (for example, LDPC coding) is performed on the obtained CB. For example, an encoded sequence corresponding to the CB is generated by using a generator matrix and the CB. There is a correspondence between the generator matrix and the check matrix, and the generator matrix may be determined based on the check matrix. The check matrix may be a predefined matrix. An independent LDPC coding process is performed on each CB block on a downlink shared channel. If linear block code (for example, LDPC code) is used for the channel coding, calculation needs to be performed based on a corresponding check matrix to perform encoding or decoding on each CB block. For the linear block code, the check matrix is a matrix with a dimension of $M * N$, where $N$ is a length of the encoded sequence output after the channel coding. $M = N - K$, where $K$ indicates a length of an information sequence before the channel coding. The check matrix of the LDPC code presents a feature of a sparse matrix, that is, a large quantity of elements in the check matrix are 0. The check matrix of the NR LDPC code can flexibly adapt to different code lengths and code rates.

Optionally, in this embodiment of this application, the downlink data is coded by using the linear block code. For example, the linear block code may include Hamming code, cyclic code, the LDPC code, and the like. In the coding scheme of the linear block code, the information sequence is divided into groups of a fixed length. Specifically, the group includes a check bit and an information bit, and the check bit and the information bit are in a linear relationship. For example, for [n, k] linear block code, the information sequence is divided into segments of k information sequence elements. Each segment may be converted into n information sequence elements via the encoder, and the n information sequence elements are used as one codeword of the [n, k] linear block code. The information sequence element may be understood as an element of the unencoded sequence or the encoded sequence.

For the linear block code, a relationship shown in Formula 1-3 exists:

$$B = YG \qquad\qquad \text{Formula 1-3}$$

$B$ indicates the encoded sequence corresponding to the CB, and a dimension is 1*N. $Y$ is the information sequence, namely, the unencoded sequence corresponding to the CB, and a dimension is 1*K. $G$ is a K*N generator matrix.

Corresponding to the generator matrix, there is a check matrix $H$ that describes the linear block code. For a relationship between the check matrix and $B$, refer to Formula 1-4:

$$BH^T = 0 \qquad\qquad \text{Formula 1-4}$$

$H$ indicates the check matrix corresponding to the CB coding, and a dimension is $M * N$. $M = N - K$, where $N$ indicates a length of the encoded sequence corresponding to the CB, and $K$ indicates a length of the unencoded sequence corresponding to the CB. Formula 1-4 may alternatively be indicated as $HB^T = 0$. It should be noted that, for binary coding, $N$ indicates a length of an encoded bit sequence corresponding to the CB, and $K$ indicates a length of an unencoded bit sequence corresponding to the CB. For the receiving end, in a decoding detection process, whether a specific codeword is a valid encoded codeword may be determined according to a check equation (for example, Formula 1-4).

In a fourth step, processing such as rate matching, a HARQ operation, and interleaving is performed on an obtained encoded sequence corresponding to each CB.

In a fifth step, a plurality of code blocks are combined on a result obtained in the fourth step, to generate a bit stream whose length is L. Then, to effectively transmit data over an air interface, processes such as bit-level scrambling, data modulation, layer mapping, precoding, and RE mapping need to be subsequently performed on the bit stream.

S102: After the downlink data is received from the network device, determine, based on the downlink data, a decoded sequence obtained by performing channel decoding on the downlink data.

The decoded sequence is an estimation result of the CB, and one decoded sequence corresponds to one CB. Optionally, the decoded sequence may alternatively be understood as an estimation result of an information sequence corresponding to the code block, or may be an estimation result of the encoded sequence corresponding to the code block. The information sequence corresponding to the code block may alternatively be referred to as the unencoded sequence corresponding to the code block. For binary channel coding, the information sequence corresponding to the code block may alternatively be referred to as information corresponding to the code block, or the unencoded bit sequence corresponding to the code block. The encoded sequence corresponding to the code block may alternatively be referred to as the encoded bit sequence corresponding to the code block. The estimation result may be understood as a decision result, obtained through the channel decoding, of the unencoded sequence or the encoded sequence corresponding to the CB. The estimation result is also a sequence. Optionally, there is a one-to-one correspondence between the element in the unencoded sequence or the encoded sequence corresponding to the CB and an element in the estimation result. For example, in an implementation, the decoded sequence may be a hard decision result of soft information output through the channel decoding.

It should be noted that there are a plurality of manners of decoding the downlink data. For example, the decoding manner may include standard array decoding, syndrome decoding, and the like. For LDPC decoding, BP decoding, Log-BP decoding, or the like may be used. The decoding manner is not limited in this embodiment of this application.

S103: The terminal device sends indication information to the network device, where the indication information indicates first information, the first information is determined based on a quantity of non-zero elements or a quantity of zero elements included in first data, and the first data is determined based on the decoded sequence.

One piece of first data corresponds to one CB. Because one decoded sequence corresponds to one CB, it may be understood that one piece of first data corresponds to one decoded sequence. Specifically, the first data is related to $C$ and $H$, $C$ is the decoded sequence (namely, a sequence) obtained by performing the channel decoding on the downlink data, the decoded sequence is the estimation result of the CB, and $H$ is the check matrix corresponding to the CB.

In some embodiments, the first data is $A$, and $A = CH^T$, or $A = HC^T$. Optionally, the first data may alternatively be indicated by another equivalent mathematical variation (for example, an operation like a transpose or a conjugate transpose) of $CH^T$, where $C$ is a vector of $1 \times (N - K)$, and $H$ is a matrix of $(N - K) \times N$. Alternatively, the first data may be in another mathematical representation form. For example, multiplication of a matrix may alternatively be indicated as multiplication of a vector, or multiplication and/or addition of a corresponding element, provided that a quantity of included non-zero elements or a quantity of zero elements is the same as the quantity of the non-zero elements or the quantity of the zero elements included in $CH^T$ or $HC^T$. These all fall within the protection scope of the present invention.

In the following embodiments, $A = CH^T$ is used as an example for description. It should be noted that, in the following content, $CH^T$ may be replaced with $HC^T$ or another equivalent mathematical variation of $CH^T$ (for example, the operation like the transpose or the conjugate transpose). For example, $D(CH^T)$ may be equivalent to $D(HC^T)$, or may be equivalent to $D(A)$. $W(CH^t)$ may be equivalent to $W(HC^T)$, or may be equivalent to $W(A)$. In addition, equivalent replacement may also be performed on an expression in which a subscript exists. For example, $C_j H_j^T$ may be equivalent to $H_j C_j^T$, or may be equivalent to $A_j$. Various equivalent variations of an expression do not affect application of this embodiment of this application.

For example, the downlink data corresponds to two CBs (a CB 1 and a CB 2), and the CBs use the low-density parity-check LDPC code. For the sending end (namely, the network device) of the CB 1 and the CB 2, it is assumed that $x_1 = \begin{bmatrix} x_1^1 & x_2^1 & \dots & x_{N_1}^1 \end{bmatrix}$ and $x_2 = \begin{bmatrix} x_1^2 & x_2^2 & \dots & x_{N_2}^2 \end{bmatrix}$ indicate encoded sequences corresponding to a first CB (the CB 1) and a second CB (the CB 2) respectively. A length of the encoded sequence corresponding to the CB 1 is $N_1$, and a length of the encoded sequence corresponding to the CB 2 is $N_2$. A length of an unencoded sequence corresponding to the CB 1 is $K_1$, and a length of an encoded sequence corresponding to the CB 2 is $K^2$. A check matrix corresponding to the CB 1 is $H_1$, and a check matrix corresponding to the CB 2 is $H_2$.

For the receiving end (namely, the terminal device) of the CB 1 and the CB 2, if decoding is correct after the channel decoding, there is a relationship shown in Formula 1-5:

$$C_1 H_1^T = 0$$

$$C_2 H_2^T = 0 \qquad\qquad \text{Formula 1-5}$$

$C_1$ is a decoded sequence corresponding to the CB 1 (or referred to as a decoded sequence corresponding to $x_1$), and $C_2$ is a decoded sequence corresponding to the CB 2 (or referred to as a decoded sequence corresponding to $x_2$). If there is an error in decoding after the channel decoding, $C_1 H_1^T \neq 0$, and $C_2 H_2^T \neq 0$. The CB 1 is used as an example. First data $C_1 H_1^T$ corresponding to the CB 1 is a vector of $1*(N - K)$, a quantity of non-zero elements in the first data ($N - K$ elements) corresponding to the CB 1 may be denoted as $D\left(C_1 H_1^T\right)$, and a proportion of the non-zero element in the first data corresponding to the CB 1 may be denoted as $\rho = D\left(C_1 H_1^{~T}\right) / \left(N_1 - K_1\right)$. Similarly, a quantity of non-zero elements in first data corresponding to the CB 2 may be denoted as $D\left(C_2 H_2^T\right)$, and a proportion of the non-zero element in the first data corresponding to the CB 1 may be denoted as $\rho = D\left(C_2 H_2^{~T}\right) / \left(N_2 - K_2\right)$. The relationship shown in Formula 1-5 may alternatively be indicated as $H_1 C_1^T$, and $H_2 C_2^T = 0$. The first data corresponding to the CB 1 and the CB 2 is $H_1 C_1^T$ and $H_2 C_2^T$ respectively.

The first information is at least one of the following information: a quantity of non-zero elements included in first data corresponding to at least one of the one or more CBs, a proportion of a non-zero element included in first data corresponding to at least one of the one or more CBs, an average value of quantities of non-zero elements included in first data corresponding to at least one of the one or more CBs, a sum of quantities of non-zero elements included in first data corresponding to at least one of the one or more CBs, an average value of proportions of non-zero elements included in first data corresponding to at least one of the one or more CBs, a BLER corresponding to the at least one of the one or more CBs, or a BLER corresponding to a CB set including the plurality of CBs.

Optionally, the first information may alternatively be at least one of the following information: a maximum value of quantities of non-zero elements included in first data corresponding to at least one of the one or more CBs, a minimum value of quantities of non-zero elements included in first data corresponding to at least one of the one or more CBs, a maximum value of proportions of non-zero elements included in first data corresponding to at least one of the one or more CBs, or a minimum value of proportions of non-zero elements included in first data corresponding to at least one of the one or more CBs.

Optionally, the first information may alternatively be at least one of the following information: a quantity of zero elements included in first data corresponding to at least one of the one or more CBs, a proportion of a zero element included in first data corresponding to at least one of the one or more CBs, an average value of quantities of zero elements included in first data corresponding to at least one of the one or more CBs, a sum of quantities of zero elements included in first data corresponding to at least one of the one or more CBs, an average value of proportions of zero elements included in first data corresponding to at least one of the one or more CBs, a maximum value of quantities of zero elements included in first data corresponding to at least one of the one or more CBs, a minimum value of quantities of zero elements included in first data corresponding to at least one of the one or more CBs, a maximum value of proportions of zero elements included in first data corresponding to at least one of the one or more CBs, or a minimum value of proportions of zero elements included in first data corresponding to at least one of the one or more CBs.

It should be noted that the first information may reflect an error rate representation of an actual data transmission process (namely, a downlink data transmission process). In other words, the first information may be used to measure an error rate in the downlink data transmission process, and a value of the first information is related to a value of the error rate. For example, if the first information is the proportion of the non-zero element included in the first data corresponding to the at least one of the one or more CBs, a larger value of the first information indicates a higher error rate. However, the value of the first information is not necessarily positively correlated with the error rate. For example, if the first information is the proportion of the zero element included in the first data corresponding to the at least one of the one or more CBs, a smaller value of the first information indicates a higher error rate.

A reason why the first information may be used to measure the error rate in the downlink data transmission process is that, in a case, the first information is related to the quantity or the proportion of the non-zero elements/non-zero element (or the zero elements/zero element) included in the first data corresponding to the CB. There is a correspondence between the BLER corresponding to the CB and the quantity of the non-zero elements (or the zero elements) included in the first data corresponding to the CB, or there is a correspondence between the BLER corresponding to the CB and the proportion of the non-zero element (or the zero element) included in the first data corresponding to the CB. Based on the correspondence, the quantity or the proportion of the non-zero elements/non-zero element (or the zero elements/zero element) may indicate the block error rate corresponding to the CB. It should be noted that the BLER corresponding to the CB may alternatively be another statistical form indicating the error rate, for example, a bit error rate (bit error rate, BER) or a frame error rate (or referred to as a frame error rate) (frame error rate, FER). The following uses the BLER as an example for description. In another case, the first information is the BLER. Because the block error rate is an indicator for measuring a data transmission error rate, the first information may be used to measure the error rate in the downlink data transmission process. That the indication information indicates the first information may be understood as that the indication information may indicate the error rate representation of the downlink data transmission process. The network device may obtain, based on the first information, the error rate representation in the downlink data transmission process. Compared with an ACK/NACK transmission result, the error rate representation can provide more detailed adjustment information. In this way, CQI adjustment efficiency can be improved, thereby assisting the network device in better selecting an appropriate configuration parameter (for example, an MCS or a downlink data block size) for downlink transmission for the terminal device, optimizing a channel capability, and improving a throughput rate of a communication system.

The following further describes the first information.

In a first possible case, the first information is the proportion of the non-zero element included in the first data corresponding to the at least one of the one or more CBs. There is a correspondence between a proportion of a non-zero element included in first data corresponding to a CB and a BLER corresponding to the CB. For example, Table 3 describes an example of correspondences between proportions of non-zero elements and BLERs.

**Table 3**

| MCS=10 | | MCS=15 | |
|---|---|---|---|
| Proportion of a non-zero element ($\rho$) | BLER | Proportion of a non-zero element ($\rho$) | BLER |
| 59% | 0.995 | 63% | 0.993 |
| 47% | 0.634 | 51% | 0.672 |
| 32% | 0.0718 | 38% | 0.1305 |
| 21% | 0.0017 | 26% | 0.00517 |

It can be learned from Table 3 that, for cases in which the MCS is 10 and the MCS is 15, when the BLER is about 0.99, the proportion of the non-zero element is about 60%. When the BLER is about 0.65, the proportion of the non-zero element is about 50%. When the BLER is about 0.1, the proportion of the non-zero element is about 35%. When the BLER is about 0.005, the proportion of the non-zero element is about 25%. It can be learned that a higher proportion of the non-zero element indicates a larger BLER. It should be noted that each piece of data shown in Table 3 is not an absolute value, and in actual application, there may be another corresponding case. The indication information may indicate the proportion of the non-zero element included in the first data corresponding to the at least one of the one or more CBs. The network device that receives the indication information may determine, based on the indication information, the BLER corresponding to the CB. Further, a scheduling parameter corresponding to the terminal device may be adjusted based on the BLER.

In a possible implementation, the proportion of the non-zero element included in the first data corresponding to the CB may be a calculated actual value. Specifically, the proportion of the non-zero element included in the first data is $\rho$, and $\rho = D(CH^T)/(N-K)$, where $D(CH^T)$ is a quantity of non-zero elements included in the first data, $N$ is a length of an encoded sequence corresponding to the CB, and $K$ is a length of an unencoded sequence corresponding to the CB.

For example, the downlink data includes Q CBs. A quantity $D\left(C_j H_j^{T}\right)$ of non-zero elements included in first data corresponding to a $j^{th}$ CB is calculated based on the decoded sequence obtained by performing the channel decoding by the terminal device, and further a proportion $\rho_j = D\left(C_j H_j^{T}\right)/\left(N_j - K_j\right)$ of the non-zero element included in the first data corresponding to the $j^{th}$ CB is calculated, where $j$=1, 2, ..., and $Q$, that is, $j$ is a positive integer less than Q.

In a specific example, if $C_j H_j^{T} = \begin{bmatrix} 0 & 1 & 0 & 0 & 1 & 0 & 0 & 0 & 0 & 1 & 0 & 0 & 1 & 0 & 0 \end{bmatrix}$, $N_j$=15, and $K_j$=7, the quantity of the non-zero elements included in the first data corresponding to the $j^{th}$ CB is denoted as $D\left(C_j H_j^{T}\right) = 4$, and further the proportion of the non-zero element included in the first data corresponding to the $j^{th}$ CB is calculated,

that is, $\rho = D\left(C_j H_j^{T}\right)/\left(N_j - K_j\right) = 4/(15-7) = 0.5$. The first information is the proportion of the non-zero element included in the first data corresponding to the at least one of the one or more CBs. For example, the at least one CB is first $P$ CBs in the $Q$ CBs, where $P$ is a positive integer, and $1 \le P \le Q$. The first information is a proportion

$\rho_i = D\left(C_i H_i^{T}\right)/\left(N_i - K_i\right)$ of a non-zero element included in first data respectively corresponding to the $P$ CBs, where i=1, 2, ..., and $P$.

In another possible implementation, the proportion of the non-zero element included in the first data corresponding to the CB may be one of a plurality of preset proportions. In this case, the first information includes one or more preset proportions. Because a value of the preset proportion is fixed, a small quantity of bits may indicate the first information. In this manner, a length of the indication information can be reduced, and overheads can be reduced. Optionally, the proportion of the non-zero element included in the first data is a first proportion, and in a value set of the proportion, an absolute value of a difference between the first proportion and an actually calculated proportion of the non-zero element included in the first data is the smallest.

Optionally, one preset proportion may correspond to one indicator index. In a case, a value of the preset proportion may be selected at an equal interval between 0 and 1. In other words, the plurality of preset proportions form an arithmetic sequence. For example, 2 bits may be used as the indicator index. In this indication manner, four different index values may be indicated, and each index value corresponds to one preset proportion. The preset proportion may sequentially increase from 0% to 90% by using 0.3 as a step. Table 4 describes an example of correspondences between indicator indices and preset proportions.

**Table 4**

| Indicator index (index) | Preset proportion |
|---|---|
| 00 | 0% |
| 01 | 30% |
| 10 | 60% |
| 11 | 90% |

When determining the indication information, the terminal device may compare the calculated actual value of the proportion of the non-zero element included in the first data with the value of the preset proportion, and select a closest preset proportion for indication, that is, indicate an indicator index corresponding to the closest preset proportion. Alternatively, a maximum preset proportion that is not greater than the actual value of the proportion of the non-zero element included in the first data is selected, or a minimum preset proportion that is not less than the actual value of the proportion of the non-zero element included in the first data is selected. For example, the calculated actual value of the proportion of the non-zero element included in the first data is 35%, and the correspondence in Table 4 is used. If the closest preset proportion is selected for indication, the selected closest preset proportion is 30%, and the indicator index should be 01. If the maximum preset proportion that is not greater than the actual value of the proportion of the non-zero element included in the first data is selected for indication, the selected preset proportion is 30%, and the indicator index should be 01. If the minimum preset proportion that is not less than the actual value of the proportion of the non-zero element included in the first data is selected for indication, the selected preset proportion is 60%, and the indicator index should be 10.

In the foregoing case, the preset proportion is designed at an equal interval, and an adjacent interval is 30%. In another case, the preset proportion may alternatively be designed according to another criterion. For example, there is the correspondence between the proportion of the non-zero element included in the first data corresponding to the CB and the BLER corresponding to the CB, and the value of the preset proportion may be obtained based on a preset BLER. For example, the preset BLER may be 0, 0.01, 0.1, or 0.6, and a corresponding preset proportion may be 0%, 26%, 35%, or 45%. Similarly, 2 bits may be used as the indicator index. In this indication manner, four different index values may be indicated, and each index value corresponds to one preset proportion. Table 5 describes an example of correspondences between indicator indices, preset proportions, and preset BLERs.

**Table 5**

| Indicator index (index) | Preset proportion | Preset BLER |
|---|---|---|
| 00 | 0% | 0 |
| 01 | 26% | 0.01 |
| 10 | 35% | 0.1 |
| 11 | 45% | 0.6 |

In this case, because there is the correspondence between the indicator index, the preset proportion, and the preset BLER, the indicator index may also be considered as indicating a BLER corresponding to one CB. The BLER corresponding to the CB is one of a plurality of preset BLERs. When the terminal device determines the indication information, for how to determine the value of the indicator index based on the actual proportion value, refer to the descriptions of the foregoing content. Details are not described herein again.

In a second possible case, the first information includes the quantity of the non-zero elements (or the quantity of the zero elements) included in the first data corresponding to the at least one of the one or more CBs. For the receiving end of the indication information, namely, the network device, a total quantity of elements in the first data corresponding to one CB is known, that is, a value of $N - K$. The network device may determine, based on the quantity of the non-zero elements (or the quantity of the zero elements), a proportion of the non-zero element included in the first data. Based on the content described above, it can be learned that there is the correspondence between the proportion of the non-zero element included in the first data corresponding to the CB and the BLER corresponding to the CB. In addition, because the proportion of the non-zero element is determined based on the quantity of the non-zero elements, it may be understood that, there is a correspondence between the quantity of the non-zero elements included in the first data corresponding to the CB and the BLER corresponding to the CB.

Similar to the first possible case, optionally, the quantity of the non-zero elements included in the first data corresponding to the CB may be an actual value. For example, the downlink data includes $Q$ CBs. A quantity $D\left(C_j H_j^T\right)$ of non-zero elements included in first data corresponding to a $j^{th}$ CB is calculated based on the decoded sequence obtained by performing the channel decoding by the terminal device, where $j$=1, 2, ..., and $Q$, that is, $j$ is a positive integer less than $Q$. In a specific example, if $C_j H_j^T = \begin{bmatrix} 0 & 1 & 0 & 0 & 0 & 1 & 0 & 0 & 0 & 1 & 0 & 0 & 0 & 0 & 0 \end{bmatrix}$, the quantity of the non-zero elements included in the first data corresponding to the $j^{th}$ CB is denoted as $D\left(C_j H_j^T\right) = 3$. The first information is the quantity of the non-zero elements included in the first data corresponding to the at least one of the one or more CBs. For example, the at least one CB is first $P$ CBs in the $Q$ CBs, where $P$ is a positive integer, and $1 \le P \le Q$. The first information is a quantity $D\left(C_i H_i^T\right)$ of non-zero elements included in first data respectively corresponding to the $P$ CBs, where i=1, 2, ..., and $P$.

Optionally, the quantity of the non-zero elements included in the first data corresponding to the CB may be one of a plurality of preset quantities. One preset quantity may correspond to one indicator index. The plurality of preset quantities form an arithmetic sequence. A value of the preset quantity may be obtained based on a preset BLER, or there may be another selection rule for the preset quantity. Similarly, an actual value of an actual quantity of non-zero elements included in the first data may be compared with the plurality of preset quantities, a preset quantity closest to the actual quantity is selected for indication, and an index corresponding to the preset quantity is determined. The index is indicated by using a bit value. Optionally, a maximum preset quantity that is not greater than the actual value of the quantity of the non-zero elements included in the first data is selected, or optionally, a minimum preset quantity that is not less than the actual value of the quantity of the non-zero elements included in the first data is selected.

In a third possible case, the first information is the average value of the proportions of the non-zero elements included in the first data corresponding to the at least one of the one or more CBs. The average value (or referred to as an average number or a value of an average number) is a quantity that indicates a centralization trend of a group of data, is obtained by dividing a sum of all data in the group of data by a quantity of pieces of data in the group of data, and is an indicator that reflects the centralization trend of the data. In this manner, the indication information may indicate the proportion of the non-zero element that corresponds to the downlink data and that has the concentration trend (namely, the proportion of the non-zero element included in the first data corresponding to the CB, for ease of description, a short name is provided herein, and details are not described again in subsequent content), so that an average status of the data can be reflected, and impact of a specific piece of erroneous data on accuracy of the indication information can be reduced.

For example, the downlink data includes $Q$ CBs. A quantity $D\left(C_j H_j^T\right)$ of non-zero elements included in first data corresponding to a $j^{th}$ CB is calculated based on the decoded sequence obtained by performing the channel decoding by the terminal device, and further a proportion $\rho_j = D\left(C_j H_j^T\right) / \left(N_j - K_j\right)$ of the non-zero element included in the first data corresponding to the $j^{th}$ CB is calculated, where $j$=1, 2, ..., and $Q$, that is, $j$ is a positive integer less than $Q$. In a specific example, if $C_j H_j^T = \begin{bmatrix} 0 & 1 & 0 & 0 & 1 & 0 & 0 & 0 & 0 & 1 & 0 & 0 & 1 & 0 & 0 \end{bmatrix}$, $N_j$=15, and $K_j$=7, the quantity of the non-zero elements included in the first data corresponding to the $j^{th}$ CB is denoted as $D\left(C_j H_j^T\right) = 4$, and further the proportion of the non-zero element included in the first data corresponding to the $j^{th}$ CB is calculated, that is, $\rho_j = D\left(C_j H_j^T\right) / \left(N_j - K_j\right) = 4 / \left(15 - 7\right) = 0.5$. The first information is the average value of the proportions of the non-zero elements included in the first data corresponding to the at least one of the one or more CBs. For example, the at least one CB is first $P$ CBs in the $Q$ CBs, where $P$ is a positive integer, and $1 \le P \le Q$. A proportion of a non-zero element included in first data corresponding to an $i^{th}$ CB is denoted as $\rho_i = D\left(C_i H_i^T\right) / \left(N_i - K_i\right)$, where i=1, 2, ..., and $P$. The first information is an average value of proportions of non-zero elements included in first data respectively corresponding to the $P$ CBs. In an implementation, the first information may be obtained through calculation according

$$\overline{\rho} = \frac{\sum_{i=1}^{P} D\left(C_i H_i^T\right)}{\sum_{i=1}^{P}\left(N_i - K_i\right)}$$

to the following formula: . When values of $N_i$ of all CBs are the same, and $K_i$ of all the CBs are the same (that is, $N_i = N$ and $K_i = K$), the first information may be obtained through calculation according to the

$$\overline{\rho} = \frac{\sum_{i=1}^{P} D\left(C_i H_i^T\right)}{P\left(N - K\right)}$$

following formula: . In another implementation, the first information may be an arithmetic average value of proportions of non-zero elements corresponding to one or more CBs. In other words, the first information may be obtained through calculation according to the following formula:

$$\overline{\rho} = \sum_{i=1}^{P} \rho_i / P$$
.

Optionally, the first information may alternatively be a median value of the proportions of the non-zero elements included in the first data corresponding to the at least one of the one or more CBs. A median value (or referred to a median, or a value of a median) is a value in a middle position in a group of data arranged in a sequence of values, and indicates a value in a sample, population, or probability distribution. For a limited data set, after all observed values (that is, the proportions of the plurality of non-zero elements in this embodiment of this application) are sorted, one in the middle may be found as the median value. If there are an even quantity of observed values, an average number of two values in the middle is used as the median value. For example, the proportions of the non-zero elements included in the first data corresponding to the at least one of the one or more CBs are sorted in descending order as follows: 26%, 27%, 30%, 33%, 34%, 34%, and 35%. In this case, the first information is 33%.

In this manner, the indication information may indicate the proportion of the non-zero element that corresponds to the downlink data and whose value is located in the middle. This can reduce impact of an extreme value (for example, a maximum value or a minimum value) in the proportions of the non-zero elements may be eliminated, thereby reducing the impact of the specific piece of erroneous data on the accuracy of the indication information.

Optionally, the first information may alternatively be a mode value of the proportions of the non-zero elements included in the first data corresponding to the at least one of the one or more CBs. A mode value (or referred to as a mode, a value of a mode, a norm, or a dense number) is a value that has an obvious centralization trend point in statistical distribution, indicates a general level of the data, and may be understood as a value that appears most frequently in a group of data. In some cases, there may be several modes in a group of data. In this embodiment of this application, if there are a plurality of mode values, optionally, the plurality of mode values may all be used as the first information, or an average value of the plurality of mode values may be used as the first information. For example, the proportions of the non-zero elements included in the first data corresponding to the at least one of the one or more CBs are 26%, 27%, 30%, 33%, 34%, 34%, and 35%. In this case, the first information is 34%.

In this manner, the indication information may indicate the proportion of the non-zero element that corresponds to the downlink data and that appears most frequently, so that most statuses in the data can be reflected, thereby reducing the impact of the specific piece of erroneous data on the accuracy of the indication information.

It should be noted that for an indication manner of the proportion of the non-zero element, refer to the description of the related content in the foregoing first possible case. Details are not described herein again.

In a fourth possible case, the first information is the average value of the quantities of the non-zero elements (or the quantities of the zero elements) included in the first data corresponding to the at least one of the one or more CBs. Based on the descriptions of the foregoing content, it can be learned that there is the correspondence between the quantity of the non-zero elements included in the first data corresponding to the CB and the BLER corresponding to the CB. In this manner, the indication information may indicate the quantity of the non-zero elements that correspond to the downlink data and that has a concentration trend (namely, the quantity of the non-zero elements included in the first data corresponding to the CB, for ease of description, a short name is provided herein, and details are not described again in subsequent content). In this way, an average status of the data can be reflected, and impact of a specific piece of erroneous data on accuracy of the indication information can be reduced.

For example, the downlink data includes Q CBs. A quantity $D\left(C_j H_j^T\right)$ of non-zero elements included in first data corresponding to a $j^{th}$ CB is calculated based on the decoded sequence obtained by performing the channel decoding by the terminal device, where $j$=1, 2, ..., and Q, that is, $j$ is a positive integer less than Q. In an example, if

$$C_j H_j^T = \begin{bmatrix} 0 & 1 & 0 & 0 & 1 & 0 & 0 & 0 & 0 & 1 & 0 & 0 & 1 & 0 & 0 \end{bmatrix}$$
, the quantity of the non-zero elements included in the first data corresponding to the $j^{th}$ CB is denoted as $D\left(C_j H_j^T\right) = 4$. The first information is the average value of the quantities of the non-zero elements included in the first data corresponding to the at least one of the one or more CBs. For example, the at least one CB is first $P$ CBs in the $Q$ CBs, where $P$ is a positive integer, and $1 \le P \le$.

A quantity of non-zero elements included in first data corresponding to an $i^{th}$ CB is $D\left(C_i H_i^T\right)$, where i=1, 2, ..., and $P$. The first information is an average value of quantities of non-zero elements included in first data respectively corresponding to the $P$ CBs.

In an implementation, the first information may be obtained through calculation according to the following formula: $\overline{D} = \sum_{i=1}^{P} D\left(C_i H_i^T\right) \dfrac{N_i - K_i}{\sum_{i=1}^{P}\left(N_i - K_i\right)}$. When values of $N_i$ of all CBs are the same, and $K_i$ of all the CBs are the same (that is, $N_i = N$ and $K_i = K$), the first information may be further obtained through calculation according to the following formula:

$$\overline{D} = \sum_{i=1}^{P} D\left(C_i H_i^T\right) \frac{N_i - K_i}{\sum_{i=1}^{P}\left(N_i - K_i\right)} = \sum_{i=1}^{P} \frac{D\left(C_i H_i^T\right)}{P} \ .$$

In another implementation, the first information may be an arithmetic average value of quantities of non-zero elements corresponding to one or more CBs. In other words, the first information may be obtained through calculation according to the following formula:

$$\overline{D} = \sum_{i=1}^{P} D\left(C_i H_i^T\right) / P \ .$$

Similarly, the first information may alternatively be a median value or mode value of the quantities of the non-zero elements (or the quantities of the zero elements) included in the first data corresponding to the at least one of the one or more CBs, so that the impact of the specific piece of erroneous data on the accuracy of the indication information can be reduced. It should be noted that for an indication manner of the quantity of the non-zero elements, refer to the description of the related content in the foregoing second possible case. Details are not described herein again.

In a fifth possible case, the first information is the sum of the quantities of the non-zero elements included in the first data corresponding to the at least one of the one or more CBs. For the receiving end (namely, the network device) of the indication information, a total quantity of elements in the first data corresponding to the one or more CBs corresponding to the downlink data is known. The network device may determine, based on the sum of the quantities of the non-zero elements (or the quantities of the zero elements), the average value of the proportions of the non-zero elements included in the first data corresponding to the one or more CBs corresponding to the downlink data. In other words, the first information is the sum of the quantities of the non-zero elements included in the first data corresponding to the at least one of the one or more CBs. The indication effect may be equivalent to that the first information is the average value of the proportions of the non-zero elements included in the first data corresponding to the at least one of the one or more CBs.

For example, the downlink data includes Q CBs. A quantity $D\left(C_j H_j^T\right)$ of non-zero elements included in first data corresponding to a $j^{th}$ CB is calculated based on the decoded sequence obtained by performing the channel decoding by the terminal device, where $j$=1, 2, ..., and Q, that is, $j$ is a positive integer less than Q. In an example, if

$C_j H_j^T = \begin{bmatrix} 0 & 1 & 0 & 0 & 1 & 0 & 0 & 0 & 0 & 1 & 0 & 0 & 1 & 0 & 0 \end{bmatrix}$, the quantity of the non-zero elements included in the first data corresponding to the $j^{th}$ CB is denoted as $D\left(C_j H_j^T\right) = 4$. The first information is the sum of the quantities of the non-zero elements included in the first data corresponding to the at least one of the one or more CBs. For example, the at least one CB is first $P$ CBs in the $Q$ CBs, where $P$ is a positive integer, and $1 \le P \le Q$. A quantity of non-zero elements included in first data corresponding to an $i^{th}$ CB is $D\left(C_i H_i^T\right)$, where i=1, 2, ..., and $P$. The first information is a sum $S_D = \sum_{i=1}^{P} D\left(C_i H_i^T\right)$ of quantities of non-zero elements included in first data respectively corresponding to the $P$ CBs.

In a sixth possible case, the first information is the BLER corresponding to the at least one of the one or more CBs, or the BLER corresponding to the CB set (for example, may be a CB group or may be a TB) including the plurality of CBs. Optionally, based on the correspondence between the BLER corresponding to the CB and the proportion (or the quantity) of the non-zero element/non-zero elements included in the first data corresponding to the CB, and the calculated proportion (or quantity) of the non-zero element/non-zero elements included in the first data corresponding to the at least one of the one or more CBs, the BLER corresponding to the at least one of the one or more CBs is determined. Alternatively, based on the correspondence between the BLER corresponding to the CB and the proportion of the non-zero element included in the first data corresponding to the CB, and the calculated average value (or the median value or the mode value) of the proportions of the non-zero elements included in the first data corresponding to the plurality of CBs, the BLER corresponding to the CB set including the plurality of CBs is determined. It should be noted that the BLER corresponding to the CB or the BLER corresponding to the CB set may alternatively be another statistical form indicating an error rate, for example, a bit error rate (bit error rate, BER) or a frame error rate (or referred to as a frame error rate) (frame error rate, FER).

Optionally, one BLER may correspond to one indicator index, and the BLER is indicated in an indicator index manner. For example, the BLER may be one of a plurality of preset BLERs. For example, for a correspondence between the indicator index and the preset BLER, refer to the example shown in Table 5.

In a seventh possible case, the first information is the maximum value of the proportions of the non-zero elements included in the first data corresponding to the at least one of the one or more CBs.

For example, the downlink data includes Q CBs. A quantity $D\left(C_j H_j^T\right)$ of non-zero elements included in first data corresponding to a $j$th CB is calculated based on the decoded sequence obtained by performing the channel decoding by the terminal device, and further a proportion $\rho_j = D\left(C_j H_j^T\right)/\left(N_j - K_j\right)$ of the non-zero element included in the first data corresponding to the $j$th CB is calculated, where $j$=1, 2, ..., and Q, that is, $j$ is a positive integer less than Q. In a specific example, if $C_j H_j^T = \begin{bmatrix} 0 & 1 & 0 & 0 & 1 & 0 & 0 & 0 & 0 & 1 & 0 & 0 & 1 & 0 & 0 \end{bmatrix}$, $N_j$=15, and $K_j$=7, the quantity of the non-zero elements included in the first data corresponding to the $j$th CB is denoted as $D\left(C_j H_j^T\right) = 4$, and further the proportion of the non-zero element included in the first data corresponding to the $j$th CB is calculated, that is, $\rho_j = D\left(C_j H_j^T\right)/\left(N_j - K_j\right) = 4/\left(15-7\right) = 0.5$. The first information is the maximum value of the proportions of the non-zero elements included in the first data corresponding to the at least one of the one or more CBs. For example, the at least one CB is first $P$ CBs in the $Q$ CBs, where $P$ is a positive integer, and $1 \le P \le Q$. A proportion of a non-zero element included in first data corresponding to an $i$th CB is denoted as $\rho_i = D\left(C_i H_i^T\right)/\left(N_i - K_i\right)$, where i=1, 2, ..., and $P$. The first information is a maximum value of proportions of non-zero elements included in first data respectively corresponding to the $P$ CBs. In an implementation, the first information may be obtained through calculation according to the following formula: $\rho_{max} = \max_{1\le P\le Q} \rho_i$.

In an eighth possible case, the first information is the minimum value of the proportions of the non-zero elements included in the first data corresponding to the at least one of the one or more CBs.

For example, the downlink data includes Q CBs. A quantity $D\left(C_j H_j^T\right)$ of non-zero elements included in first data corresponding to a $j$th CB is calculated based on the decoded sequence obtained by performing the channel decoding by the terminal device, and further a proportion $\rho_j = D\left(C_j H_j^T\right)/\left(N_j - K_j\right)$ of the non-zero element included in the first data corresponding to the $j$th CB is calculated, where $j$=1, 2, ..., and Q, that is, $j$ is a positive integer less than Q. In a specific example, if $C_j H_j^T = \begin{bmatrix} 0 & 1 & 0 & 0 & 1 & 0 & 0 & 0 & 0 & 1 & 0 & 0 & 1 & 0 & 0 \end{bmatrix}$, $N_j$=15, and $K_j$=7, the quantity of the non-zero elements included in the first data corresponding to the $j$th CB is denoted as $D\left(C_j H_j^T\right) = 4$, and further the proportion of the non-zero element included in the first data corresponding to the $j$th

CB is calculated, that is, $\rho_j = D\left(C_j H_j^T\right) / \left(N_j - K_j\right) = 4 / \left(15 - 7\right) = 0.5$. The first information is the minimum value of the proportions of the non-zero elements included in the first data corresponding to the at least one of the one or more CBs. For example, the at least one CB is first $P$ CBs in the $Q$ CBs, where $P$ is a positive integer, and $1 \le P \le Q$. A proportion of a non-zero element included in first data corresponding to an $i^{th}$ CB is denoted as

$\rho_i = D\left(C_i H_i^T\right) / \left(N_i - K_i\right)$, where i=1, 2, ..., and $P$. The first information is a minimum value of proportions of non-zero elements included in first data respectively corresponding to the $P$ CBs. In an implementation, the first information may be obtained through calculation according to the following formula:

$$\rho_{min} = \min_{1 \le P \le Q} \rho_i .$$

In a ninth possible case, the first information is the maximum value of the quantities of the non-zero elements included in the first data corresponding to the at least one of the one or more CBs.

For example, the downlink data includes Q CBs. A quantity $D\left(C_j H_j^T\right)$ of non-zero elements included in first data corresponding to a $j^{th}$ CB is calculated based on the decoded sequence obtained by performing the channel decoding by the terminal device, where $j$=1, 2, ..., and Q, that is, $j$ is a positive integer less than Q. In a specific example, if $C_j H_j^T = \begin{bmatrix} 0 & 1 & 0 & 0 & 1 & 0 & 0 & 0 & 0 & 1 & 0 & 0 & 1 & 0 & 0 \end{bmatrix}$, the quantity of the non-zero elements included in the first data corresponding to the $j^{th}$ CB is denoted as $D\left(C_j H_j^T\right) = 4$. The first information is the maximum value of the proportions of the non-zero elements included in the first data corresponding to the at least one of the one or more CBs. For example, the at least one CB is first $P$ CBs in the $Q$ CBs, where $P$ is a positive integer, and $1 \le P \le$

Q. A quantity of non-zero elements included in first data corresponding to an $i^{th}$ CB is $D\left(C_i H_i^T\right)$, where i=1, 2, ..., and $P$. The first information is a maximum value of proportions of non-zero elements included in first data respectively corresponding to the $P$ CBs. In an implementation, the first information may be obtained through calculation according to the following formula:

$$D_{max} = \max_{1 \le P \le Q} D\left(C_i H_i^T\right) .$$

In a tenth possible case, the first information is the minimum value of the proportions of the non-zero elements included in the first data corresponding to the at least one of the one or more CBs.

For example, the downlink data includes Q CBs. A quantity $D\left(C_j H_j^T\right)$ of non-zero elements included in first data corresponding to a $j^{th}$ CB is calculated based on the decoded sequence obtained by performing the channel decoding by the terminal device, where $j$=1, 2, ..., and Q, that is, $j$ is a positive integer less than Q. In a specific example, if

$C_j H_j^T = \begin{bmatrix} 0 & 1 & 0 & 0 & 1 & 0 & 0 & 0 & 0 & 1 & 0 & 0 & 1 & 0 & 0 \end{bmatrix}$, the quantity of the non-zero elements included in the first data corresponding to the $j^{th}$ CB is denoted as $D\left(C_j H_j^T\right) = 4$. The first information is the minimum value of the proportions of the non-zero elements included in the first data corresponding to the at least one of the one or more CBs. For example, the at least one CB is first $P$ CBs in the $Q$ CBs, where $P$ is a positive integer, and $1 \le P \le$

Q. A quantity of non-zero elements included in first data corresponding to an $i^{th}$ CB is $D\left(C_i H_i^T\right)$, where i=1, 2, ..., and $P$. The first information is a minimum value of proportions of non-zero elements included in first data respectively corresponding to the $P$ CBs. In an implementation, the first information may be obtained through calculation according to the following formula:

$$D_{\min} = \min_{1 \le P \le Q} D\left(C_i H_i^{T}\right)$$

.

It should be noted that, in the foregoing described content, the quantity of the non-zero elements or the proportion of the non-zero element included in the first data is used to reflect the error rate representation in the data transmission process. Because the quantity of all the elements included in the first data is known to the receiving end and the sending end of the data transmission, the quantity of the zero elements included in the first data may also provide information equivalent to the quantity of the non-zero elements. In addition, a sum of the proportion of the non-zero element and the proportion of the zero element is 1, and the proportion of the zero element may also provide information equivalent to the proportion of the non-zero element.

Based on this, it may be understood that there is the correspondence between the BLER corresponding to the CB and the quantity of the zero elements included in the first data corresponding to the CB, or there is the correspondence between the BLER corresponding to the CB and the proportion of the zero element included in the first data corresponding to the CB.

The first information may alternatively be at least one of the following information: the quantity of the zero elements included in the first data corresponding to the at least one of the one or more CBs, the proportion of the zero element included in the first data corresponding to the at least one of the one or more CBs, the average value of the quantities of the zero elements included in the first data corresponding to the at least one of the one or more CBs, the sum of the quantities of the zero elements included in the first data corresponding to the at least one of the one or more CBs, the average value of the proportions of the zero elements included in the first data corresponding to the at least one of the one or more CBs, the maximum value of the quantities of the zero elements included in the first data corresponding to the at least one of the one or more CBs, the minimum value of the quantities of the zero elements included in the first data corresponding to the at least one of the one or more CBs, the maximum value of the proportions of the zero elements included in the first data corresponding to the at least one of the one or more CBs, or the minimum value of the proportions of the zero elements included in the first data corresponding to the at least one of the one or more CBs.

In a possible implementation, the proportion of the zero element included in the first data is $R$, and $R = W(CH^{T})/(N-K)$, where $W(CH^{T})$ is the quantity of the zero elements included in the first data, $N$ is the length of the encoded sequence corresponding to the CB, and $K$ is the length of the unencoded sequence corresponding to the CB. It may be understood that $W(CH^{T})+D(CH^{T})=N-K$ and $R=1-\rho$

In a possible implementation, the first information is the proportion of the zero element included in the first data, and the proportion of the zero element is one or more of a plurality of preset proportions. Optionally, the plurality of preset proportions may form an arithmetic sequence.

For example, the downlink data includes Q CBs. A quantity of zero elements included in first data corresponding to a $j^{th}$ CB is $W\left(C_j H_j^{T}\right)$, and a proportion of the zero element included in the first data corresponding to the $j^{th}$ CB is $R_j = W\left(C_j H_j^{T}\right)/\left(N_j - K_j\right)$, where $j=1, 2, ...,$ and $Q$, that is, $j$ is a positive integer less than $Q$. The at least one CB is first $P$ CBs in the $Q$ CBs, where $P$ is a positive integer, and $1 \le P \le Q$.

Optionally, the first information is the quantity of the zero elements included in the first data corresponding to the at least one of the one or more CBs. In an implementation, the first information is a quantity $W\left(C_i H_i^{T}\right)$ of zero elements included in first data respectively corresponding to the $P$ CBs, where i=1, 2, ..., and $P$.

Optionally, the first information is the proportion of the zero element included in the first data corresponding to the at least one of the one or more CBs. In an implementation, the first information is a proportion of a zero element included in first data respectively corresponding to the $P$ CBs, which can be obtained through calculation according to the following formula:

$$R_i = W\left(C_i H_i^{T}\right)/\left(N_i - K_i\right),$$

where i=1, 2, ..., and $P$.

Optionally, the first information is the average value of the proportions of the zero elements included in the first data corresponding to the at least one of the one or more CBs. In an implementation, the first information may be obtained

$$\overline{R} = \frac{\sum_{i=1}^{P} W\left(C_i H_i^T\right)}{\sum_{i=1}^{P}\left(N_i - K_i\right)}$$

through calculation according to the following formula: . When values of $N_i$ of all CBs are the same, and $K_i$ of all the CBs are the same (that is, $N_i = N$ and $K_i = K$), the first information may be further obtained through

$$\overline{R} = \frac{\sum_{i=1}^{P} W\left(C_i H_i^T\right)}{P\left(N - K\right)}$$

calculation according to the following formula: . In another implementation, the first information may be an arithmetic average value of proportions of zero elements corresponding to one or more CBs. In other words, the first information may be obtained through calculation according to the following formula: $\overline{R} = \sum_{i=1}^{P} \rho_i / P$ .

Optionally, the first information is the sum of the quantities of the zero elements included in the first data corresponding to the at least one of the one or more CBs, and in an implementation, is a sum of quantities of zero elements included in first data respectively corresponding to the $P$ CBs, which can be obtained through calculation according to the following formula:

$$S_W = \sum_{i=1}^{P} W\left(C_i H_i^T\right).$$

Optionally, the first information is the average value of the quantities of the zero elements included in the first data corresponding to the at least one of the one or more CBs. In an implementation, the first information may be obtained

$$\overline{W} = \sum_{i=1}^{P} W\left(C_i H_i^T\right) \frac{N_i - K_i}{\sum_{i=1}^{P}\left(N_i - K_i\right)}$$

through calculation according to the following formula: . When values of $N_t$ of all CBs are the same, and $K_i$ of all the CBs are the same (that is, $N_i = N$ and $K_i = K$), the first information may be further obtained through calculation according to the following formula:

$$\overline{W} = \sum_{i=1}^{P} W\left(C_i H_i^T\right) \frac{N_i - K_i}{\sum_{i=1}^{P}\left(N_i - K_i\right)} = \sum_{i=1}^{P} \frac{W\left(C_i H_i^T\right)}{P} .$$

In another implementation, the first information may be an arithmetic average value of proportions of zero elements corresponding to one or more CBs. In other words, the first information may be obtained through calculation according to the following formula:

$$\overline{W} = \sum_{i=1}^{P} W\left(C_i H_i^T\right) / P .$$

Optionally, the first information is alternatively the maximum value of the quantities of the zero elements included in the first data corresponding to the at least one of the one or more CBs. In an implementation, the first information may be obtained through calculation according to the following formula:

$$W_{\max} = \max_{1 \le P \le Q} W\left(C_i H_i^T\right).$$

Optionally, the first information is the minimum value of the quantities of the zero elements included in the first data corresponding to the at least one of the one or more CBs. In an implementation, the first information may be obtained through calculation according to the following formula:

$$W_{\min} = \min_{1 \le P \le Q} W\left(C_i H_i^T\right).$$

Optionally, the first information is the maximum value of the proportions of the zero elements included in the first data corresponding to the at least one of the one or more CBs. In an implementation, the first information may be obtained through calculation according to the following formula:

$$R_{max} = \max_{1 \leq P \leq Q} R_i .$$

Optionally, the first information is alternatively the minimum value of the proportions of the zero elements included in the first data corresponding to the at least one of the one or more CBs. In an implementation, the first information may be obtained through calculation according to the following formula:

$$R_{min} = \min_{1 \leq P \leq Q} R_i .$$

In an eleventh possible case, the first information is a configuration parameter adjustment amount for the downlink transmission (for example, may be a power adjustment amount, a signal-to-noise ratio (or a signal to interference plus noise ratio or an SINR) adjustment amount, a TB size adjustment amount, or the like). It should be noted that there is a correspondence between the configuration parameter adjustment amount for the downlink transmission and the BLER corresponding to the CB, or it may be referred to that there is a correspondence between the configuration parameter adjustment amount for the downlink transmission and a difference between the BLER corresponding to the CB and the target BLER (the preset BLER that the downlink transmission expects to reach).

It can be learned from the description of the content of the foregoing embodiment that, there is the correspondence between the BLER corresponding to the CB and the quantity of the non-zero elements (or the zero elements) included in the first data corresponding to the CB, or there is the correspondence between the BLER corresponding to the CB and the proportion of the non-zero element (or the zero element) included in the first data corresponding to the CB. Based on the correspondence, the terminal device can determine, based on the quantity or the proportion of the non-zero elements/the non-zero element (or the zero elements/the zero element) included in the first data corresponding to the CB, the BLER corresponding to the CB. In addition, specifically, the terminal device may pre-obtain, based on a used receiver algorithm, a correspondence between an SINR and a BLER at the receiving end for a preset configuration parameter (for example, power, an MCS, or a rank) for the downlink transmission. The terminal device may determine, based on the BLER corresponding to the CB and the correspondence between the SINR and the BLER at the receiving end, the SINR adjustment amount that is for the downlink transmission and that is required to reach the preset BLER. In addition, the terminal device may further simulate noise loading on a received signal corresponding to current downlink transmission, to load a power value of the noise by using a model, so that a BLER corresponding to the downlink transmission reaches the preset BLER, thereby determining a noise power value that needs to be loaded to reach the target BLER. In some other embodiments, the terminal device may pre-obtain, based on a used receiver algorithm, a correspondence between downlink transmission power and a BLER for a preset configuration parameter (for example, an MCS, an SINR, or a rank) for the downlink transmission. The terminal device may determine, based on the BLER corresponding to the CB and the correspondence between the downlink transmission power and the BLER, the power adjustment amount that is for the downlink transmission and that is required to reach the preset BLER. Based on a similar principle, the terminal device may determine another configuration parameter adjustment amount for the downlink transmission.

In an implementation, it is assumed that the target BLER=0.1, and the terminal device may learn, by using one of the foregoing methods, an SINR threshold X required to reach the target BLER corresponding to an MCS used for current transmission. The first information may indicate a difference X-Y or Y-X between an SINR value Y corresponding to the current downlink data transmission and the SINR threshold X.

The following describes a manner of sending the indication information. In some possible implementations, the indication information is carried in a HARQ sent by the terminal device. In this manner, the indication information may be quickly fed back to the network device by using the HARQ, and there is no need to wait for a CSI measurement and feedback period, so that a CQI adjustment speed can be increased.

In some possible implementations, the terminal device sends the indication information to the network device over a physical uplink control channel (physical uplink control channel, PUCCH) or a PUSCH. Correspondingly, the network device receives the indication information from the terminal device over the PUCCH or the PUSCH. Optionally, in this implementation, the method further includes: The network device sends first indication information to the terminal device, where the first indication information indicates a sending period of the indication information by the terminal device. A manner in which the terminal device sends the indication information to the network device is as follows: After the terminal device receives the first indication information from the network device, and when a current moment reaches the sending period, the terminal device sends the indication information to the network device over the PUSCH or the PUCCH.

In some possible implementations, before the network device receives the indication information from the terminal device, the method further includes: The network device sends second indication information to the terminal device, where the second indication information indicates the terminal device to send the indication information. After the terminal device receives the second indication information from the network device, the terminal device sends the indication information to the network device based on the second indication information. In this manner, when the network device needs the indication information, the network device may send the second indication information to the terminal device, to obtain the indication information.

For example, the first indication information and the second indication information may be carried in at least one of the following signaling: radio resource control (radio resource control, RRC) signaling, media access control-control element (medium access control-control element, MAC-CE) signaling, and downlink control information (downlink control information, DCI). It should be noted that, with evolution of communication technologies, names of these signaling may change. In some other possible implementations, the first indication information and the second indication information may alternatively be carried in some other signaling.

In some embodiments, after the network device receives the indication information from the terminal device, the network device may determine the configuration parameter for the downlink transmission for the terminal device based on the indication information. For example, the configuration parameter may be the CQI, the MCS, the rank, the downlink data block size (for example, the TB size), or the like.

In a possible implementation, the network device may determine, based on the reported CSI information and the indication information, the configuration parameter for the downlink transmission corresponding to the terminal device. The reported CSI information may include one or more of a CQI, a PMI, an RI, and the like. Alternatively, the CQI may be another parameter that can indicate signal transmission quality, for example, an SINR, an SNR, an SLNR, or an MCS. The reported CSI information may be historically reported CSI information. In an implementation, the reported CSI information may be CSI information reported on a latest CSI reporting occasion before the indication information is received, or may be CSI information reported on a latest CSI reporting occasion before the indication information is sent. Alternatively, the reported CSI information may be CSI information reported on a latest CSI reporting occasion within a preset time window before the indication information is received, or CSI information reported on a latest CSI reporting occasion within a preset time window before the indication information is sent. For example, if a length of the time window is L time units, and a moment at which the indication information is received or the indication information is sent is t, the preset time window before the indication information is received or the preset time window before the indication information is sent is time units included in a moment $[t - L, t]$. Alternatively, the reported CSI information may be CSI information that is reported at a preset moment before the indication information is received, or CSI information that is reported at a preset moment before the indication information is sent. For example, the reported CSI information is CSI information reported at a moment $t - L$ before the indication information is received, or CSI information reported at a moment $t - L$ before the indication information is sent.

The following uses an example for description.

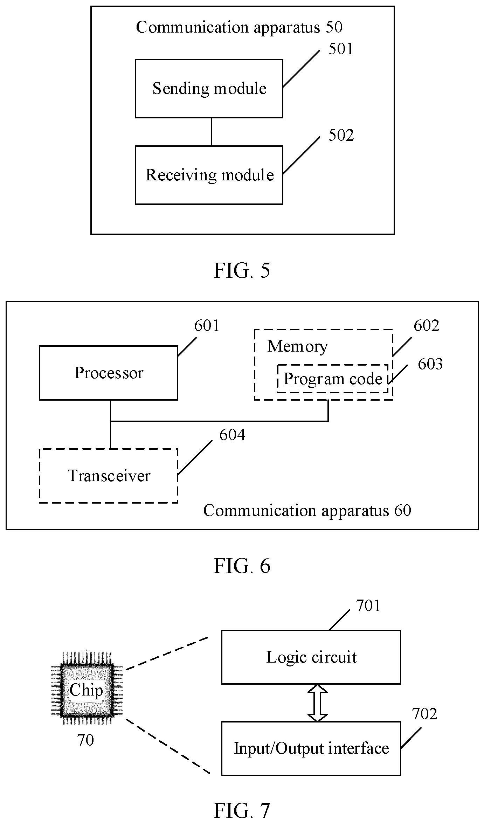

The terminal device reports a CQI index to the network device in previous CSI reporting. Specifically, CQI=8. The network device performs scheduling on the terminal device based on the reported CQI, to send downlink data. For example, the downlink data corresponds to one CB. After receiving the downlink data from the network device, the terminal device detects and decodes the downlink data. It is assumed that a proportion of a non-zero element that corresponds to the CB and that is obtained through calculation is 48%. If the indication information indicates the BLER corresponding to the at least one of the one or more CBs, and an indication rule refers to the correspondence shown in FIG. 5, the indication information includes the indicator index 11 (because the calculated proportion of the non-zero element is closest to 45% in the preset proportion).

After receiving the indication information reported by the terminal device, the network device may determine, based on the correspondence shown in Table 5, an error rate representation of the downlink data transmission process, that is, the BLER is approximately 0.6. It is assumed that a target BLER preset by the network device is 0.1. It can be learned that the BLER of the data transmission at the current stage does not meet a requirement of the target BLER, and the network device may adjust, based on the CQI index previously reported by the terminal device, an MCS corresponding to subsequent scheduling. A method for calculating the adjusted MCS may be: $SINR = SINR(CQI) - 1.5$, where $SINR(CQI)$ indicates an SINR value corresponding to the CQI index, and -1.5 may be a preset MCS adjustment value corresponding to adjusting the BLER from 0.6 to 0.1.

In this example, because the current BLER (0.6) is far greater than the target BLER (0.1), it is determined that the MCS adjustment value is the preset MCS adjustment value corresponding to adjusting the BLER from 0.6 to 0.1, and the MCS adjustment value is far greater than an adjustment step of the conventional OLLA. Therefore, according to the method in embodiments of this application, the MCS can be quickly adjusted to an appropriate level.

In another example, it is assumed that the proportion of the non-zero element that corresponds to the CB and that is obtained through calculation is 18%, and the proportion of the non-zero element obtained through calculation is closest to the preset proportion 26%. Therefore, the indicator index included in the indication information is 01. The network device receives the indication information reported by the terminal device, and determines an error rate representation of the downlink data transmission process, that is, the BLER is approximately 0.01 (lower than the target BLER=0.1). In this case, the network device may consider that although an error occurs in this transmission, an average error rate is low, which may be caused by burst strong interference or noise that affects detection performance. Therefore, the MCS should not be adjusted or slightly adjusted. For example, a method for calculating the adjusted MCS may be: $SINR = SINR(CQI) - 0.05$. It can be learned that, according to the method in embodiments of this application, excessive MCS adjustment caused by a burst error can be effectively avoided, thereby ensuring effective MCS selection.

In another possible implementation, the indication information indicates the configuration parameter adjustment amount for the downlink transmission (for example, may be the power adjustment amount, the signal-to-noise ratio (or the signal to interference plus noise ratio or the SINR) adjustment amount, the TB size adjustment amount, or the like). In this case, the network device may adjust a corresponding configuration parameter based on the indication information. For example, the indication information indicates that the SINR adjustment amount for the downlink transmission is -1. In this case, the network device decreases the current SINR by 1 based on the indication information, and uses the decreased SINR as a new SINR for the downlink transmission.

It may be understood that, to implement the functions in the foregoing embodiments, the network device and the terminal device include corresponding hardware structures and/or software modules for performing the functions. A person skilled in the art should be easily aware that, with reference to units and method steps of the examples described in embodiments disclosed in this application, this application can be implemented by using hardware or a combination of hardware and computer software. Whether a function is performed by hardware or hardware driven by computer software depends on particular application scenarios and design constraints of the technical solutions.

FIG. 4 is a diagram of a structure of a communication apparatus according to an embodiment of this application. The communication apparatus 40 includes a receiving module 401, a determining module 402, and a sending module 403. The following describes the three modules in detail.

The receiving module 401 is configured to receive downlink data from a network device, where the downlink data corresponds to one or more code blocks CBs.

The determining module 402 is configured to determine, based on the downlink data, a decoded sequence obtained by performing channel decoding on the downlink data, where the decoded sequence is an estimation result of the CB, and one decoded sequence corresponds to one CB. For an operation performed by the determining module 402, refer to the description of the content of step S102 in FIG. 3.

The sending module 403 is configured to send indication information to the network device, where the indication information indicates first information, the first information is determined based on a quantity of non-zero elements or a quantity of zero elements included in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB. For an operation performed by the sending module 403, refer to the description of the content of step S103 in FIG. 3.

In a possible implementation, the first information is at least one of the following information: a quantity of non-zero elements included in first data corresponding to at least one of the one or more CBs, a proportion of a non-zero element included in first data corresponding to at least one of the one or more CBs, an average value of quantities of non-zero elements included in first data corresponding to at least one of the one or more CBs, a sum of quantities of non-zero elements included in first data corresponding to at least one of the one or more CBs, an average value of proportions of non-zero elements included in first data corresponding to at least one of the one or more CBs, a block error rate BLER corresponding to the at least one of the one or more CBs, or a BLER corresponding to a CB set including the plurality of CBs.

In a possible implementation, the first data is $A$, and $A = CH^T$, or $A = HC^T$.

In a possible implementation, the proportion of the non-zero element included in the first data is $\rho$, and $\rho = D(A)/(N - K)$, where $D(A)$ is the quantity of the non-zero elements, $N$ is a length of an encoded sequence corresponding to the CB, and $K$ is a length of an unencoded sequence corresponding to the CB.

In a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

In a possible implementation, the first information is the proportion of the non-zero element included in the first data, and the proportion of the non-zero element is one or more of a plurality of preset proportions.

In a possible implementation, the plurality of preset proportions form an arithmetic sequence.

In a possible implementation, the downlink data is coded by using linear block code.

In a possible implementation, the indication information is carried in a hybrid automatic repeat request HARQ; or the sending module 403 is further configured to send the indication information to the network device over a physical uplink control channel PUCCH or a physical uplink shared channel PUSCH.

It should be noted that, in the foregoing embodiment, the communication apparatus 40 may be a terminal device, may be an apparatus in a terminal device, or may be an apparatus that can be used together with a terminal device. Specifically, for operations performed by the modules of the communication apparatus 40 shown in FIG. 4, refer to the related content of the terminal device in the method embodiment corresponding to FIG. 3. Details are not described herein again. The modules may be implemented by hardware, software, or a combination of software and hardware. In an embodiment, functions of the receiving module 401, the determining module 402, and the sending module 403 in the foregoing content may be implemented by one or more processors in the communication apparatus 40.

FIG. 5 is a diagram of a structure of another communication apparatus according to an embodiment of this application. The communication apparatus 50 includes a sending module 501 and a receiving module 502. The following describes the two modules in detail.

The sending module 501 is configured to send a downlink data signal to a terminal device, where the downlink data signal corresponds to one or more code blocks CBs. For an operation performed by the sending module 501, refer to the description of the content of step S101 in FIG. 3.

The receiving module 502 is configured to receive indication information from the terminal device, where the indication information indicates first information, the first information is determined based on a quantity of non-zero elements included in first data, one piece of first data corresponds to one CB, the first data is related to $C$ and $H$, $C$ is a decoded sequence obtained by performing channel decoding on downlink data, and $H$ is a check matrix corresponding to the CB.

In a possible implementation, the first information is one of the following information: a quantity of non-zero elements included in first data corresponding to each of the one or more CBs, a proportion of a non-zero element included in first data corresponding to each of the one or more CBs, an average value of quantities of non-zero elements included in first data corresponding to each of the one or more CBs, or an average value of proportions of non-zero elements included in first data corresponding to each of the one or more CBs, and a block error rate BLER corresponding to the one or more CBs.

In a possible implementation, the first data is $A$, and $A = CH^T$, or $A = HC^T$.

In a possible implementation, the proportion of the non-zero element included in the first data is $\rho$, and $\rho = D(A)/(N - K)$, where $D(A)$ is the quantity of the non-zero elements included in the first data, $N$ is a length of an encoded sequence corresponding to the CB, and $K$ is a length of an unencoded sequence corresponding to the CB.

In a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

In a possible implementation, the first information is the proportion of the non-zero element included in the first data, and the proportion of the non-zero element is one or more of a plurality of preset proportions.

In a possible implementation, the plurality of preset proportions form an arithmetic sequence.

In a possible implementation, the downlink data is coded by using linear block code.

In a possible implementation, the indication information is carried in a hybrid automatic repeat request HARQ sent by the terminal device; or the receiving module 502 is further configured to receive the indication information from the terminal device over a physical uplink control channel PUCCH or a physical uplink shared channel PUSCH.

It should be noted that in the foregoing embodiment, the communication apparatus 50 may be a network device, may be an apparatus in a network device, or may be an apparatus that can be used together with a network device. Specifically, for operations performed by the modules of the communication apparatus 50 shown in FIG. 5, refer to the related content of the network device in the method embodiment corresponding to FIG. 3. Details are not described herein again. The modules may be implemented by hardware, software, or a combination of software and hardware. In an embodiment, functions of the sending module 501 and the receiving module 502 in the foregoing content may be implemented by one or more processors in the communication apparatus 50.

FIG. 6 is a diagram of a structure of another communication apparatus according to an embodiment of this application. The communication apparatus 60 may be configured to implement the methods described in the foregoing method embodiments. For details, refer to the descriptions in the foregoing method embodiments.

The communication apparatus 60 may include one or more processors 601. The processor 601 may be a general-purpose processor, a dedicated processor, or the like. The processor 601 may be configured to: control a communication apparatus (for example, a network device, a network device chip, a terminal device, or a terminal device chip), execute a software program, and process data of the software program.

Optionally, the communication apparatus 60 may include one or more memories 602 on which program code 603 is stored, and the program code may be run on the processor 601, so that the communication apparatus 60 performs the methods described in the foregoing method embodiments. Optionally, the memory 602 may further store data. The processor 601 and the memory 602 may be disposed separately, or may be integrated together. Optionally, the memory 602 may further be located outside the communication apparatus 60, and coupled to the communication apparatus 60 in some manners.

Optionally, the communication apparatus 60 may further include a transceiver 604. The transceiver 604 may be referred to as a transceiver unit, a transceiver machine, a transceiver circuit, or the like, and is configured to implement a transceiver function. The transceiver 604 may include a receiver and a transmitter. The receiver may be referred to as a receiver machine, a receiver circuit, or the like, and is configured to implement a receiving function. The transmitter may be referred to as a transmitter machine, a transmitter circuit, or the like, and is configured to implement a sending function.

In an embodiment,

the processor 601 is configured to: receive downlink data from a network device, where the downlink data corresponds to one or more code blocks CBs; determine, based on the downlink data, a decoded sequence obtained by performing channel decoding on the downlink data, where the decoded sequence is an estimation result of the CB, and one decoded sequence corresponds to one CB; and send indication information to the network device, where the indication information indicates first information, the first information is determined based on a quantity of non-zero elements or a quantity of zero elements included in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB.

In a possible implementation, the first information is at least one of the following information: a quantity of non-zero elements included in first data corresponding to at least one of the one or more CBs, a proportion of a non-zero element included in first data corresponding to at least one of the one or more CBs, an average value of quantities of non-zero elements included in first data corresponding to at least one of the one or more CBs, a sum of quantities of non-zero elements included in first data corresponding to at least one of the one or more CBs, an average value of proportions of non-zero elements included in first data corresponding to at least one of the one or more CBs, a block error rate BLER corresponding to the at least one of the one or more CBs, or a BLER corresponding to a CB set including the plurality of CBs.

In a possible implementation, the first data is $A$, and $A = CH^T$, or $A = HC^T$.

In a possible implementation, the proportion of the non-zero element included in the first data is $\rho$, and $\rho = D(A)/(N - K)$, where $D(A)$ is the quantity of the non-zero elements included in the first data, $N$ is a length of an encoded sequence corresponding to the CB, and $K$ is a length of an unencoded sequence corresponding to the CB.

In a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

In a possible implementation, the first information is the proportion of the non-zero element included in the first data, and the proportion of the non-zero element is one or more of a plurality of preset proportions.

In a possible implementation, the plurality of preset proportions form an arithmetic sequence.

In a possible implementation, the downlink data is coded by using linear block code.

In a possible implementation, the indication information is carried in a hybrid automatic repeat request HARQ; or the processor 601 is further configured to send the indication information to the network device over a physical uplink control channel PUCCH or a physical uplink shared channel PUSCH.

It should be noted that, in the foregoing embodiment, the communication apparatus 60 may be a terminal device, or may be a chip, a chip system, a processor, or the like that supports a terminal device in implementing the foregoing method. Specifically, for operations performed by the communication apparatus 60, refer to the related content of the terminal device in the method embodiment corresponding to FIG. 3. Details are not described herein again.

In another embodiment,

the processor 601 is configured to: send a downlink data signal to a terminal device, where the downlink data signal corresponds to one or more code blocks CBs; and receive indication information from the terminal device, where the indication information indicates first information, the first information is determined based on a quantity of non-zero elements included in first data, one piece of first data corresponds to one CB, the first data is related to $C$ and $H$, $C$ is a decoded sequence obtained by performing channel decoding on downlink data, and $H$ is a check matrix corresponding to the CB.

In a possible implementation, the first information is one of the following information: a quantity of non-zero elements included in first data corresponding to each of the one or more CBs, a proportion of a non-zero element included in first data corresponding to each of the one or more CBs, an average value of quantities of non-zero elements included in first data corresponding to each of the one or more CBs, or an average value of proportions of non-zero elements included in first data corresponding to each of the one or more CBs, and a block error rate BLER corresponding to the one or more CBs.

In a possible implementation, the first data is $A$, and $A = CH^T$, or $A = HC^T$.

In a possible implementation, the proportion of the non-zero element included in the first data is $\rho$, and $\rho = D(A)/(N - K)$, where $D(A)$ is the quantity of the non-zero elements included in the first data, $N$ is a length of an encoded sequence corresponding to the CB, and $K$ is a length of an unencoded sequence corresponding to the CB.

In a possible implementation, there is a correspondence between the BLER corresponding to the CB and the quantity of the non-zero elements included in the first data corresponding to the CB, or there is a correspondence between the BLER corresponding to the CB and the proportion of the non-zero element included in the first data corresponding to the CB.

In a possible implementation, the first information is the proportion of the non-zero element included in the first data, and the proportion of the non-zero element is one or more of a plurality of preset proportions.

In a possible implementation, the plurality of preset proportions form an arithmetic sequence.

In a possible implementation, the downlink data is coded by using linear block code.

In a possible implementation, the indication information is carried in a hybrid automatic repeat request HARQ sent by the terminal device; or the processor 601 is further configured to receive the indication information from the terminal device over a physical uplink control channel PUCCH or a physical uplink shared channel PUSCH.

It should be noted that, in the foregoing embodiment, the communication apparatus 60 may be a network device, or may be a chip, a chip system, a processor, or the like that supports a network device in implementing the foregoing method. Specifically, for operations performed by the communication apparatus 60, refer to the related content of the network device in the method embodiment corresponding to FIG. 3. Details are not described herein again.

In another possible design, the transceiver may be a transceiver circuit, an interface, or an interface circuit. The transceiver circuit, the interface, or the interface circuit configured to implement receiving and sending functions may be separated, or may be integrated together. The transceiver circuit, the interface, or the interface circuit may be configured to read and write code/data. Alternatively, the transceiver circuit, the interface, or the interface circuit may be configured to transmit or transfer a signal.

In still another possible design, the communication apparatus 60 may include a circuit, and the circuit may implement a sending, receiving, or communication function in the foregoing method embodiments.

The processor and the transceiver that are described in this application may be implemented on an integrated circuit (integrated circuit, IC), an analog IC, a radio frequency integrated circuit RFIC, a hybrid signal IC, an application-specific integrated circuit (application-specific integrated circuit, ASIC), a printed circuit board (printed circuit board, PCB), an electronic device, or the like.

The communication apparatus described in the foregoing embodiments may be a network device or a terminal device. However, a scope of the communication apparatus described in this application is not limited thereto, and a structure of the communication apparatus may not be limited by FIG. 6. The communication apparatus may be an independent device or may be a part of a large device. For example, the communication apparatus may be:

(1) an independent integrated circuit IC, a chip, or a chip system or subsystem;
(2) a set having one or more ICs, and optionally, the IC set may also include a storage component configured to store data and program code;
(3) an ASIC, for example, a modem (Modem);
(4) a module that can be embedded in another device;
(5) a receiver, an intelligent terminal, a wireless device, a handset, a mobile unit, a vehicle-mounted device, a cloud device, an artificial intelligence device, or the like; or
(6) another device or the like.

For a case in which the communication apparatus may be a chip or a chip system, refer to a diagram of a structure of a chip shown in FIG. 7. The chip 70 shown in FIG. 7 includes a logic circuit 701 and an input/output interface 702. There may be one or more logic circuits 701, and there may be a plurality of input/output interfaces 702.

A case in which the chip is configured to implement the function of the terminal device in embodiments of this application is described below.

The input/output interface 702 is configured to input a downlink data signal from a network device.

The input/output interface 702 is further configured to output indication information to the network device.

The logic circuit 701 is configured to process the downlink data signal. For an operation performed by the logic circuit 701, refer to the description of the terminal device in the embodiment corresponding to FIG. 3.

A case in which the chip is configured to implement the function of the network device in embodiments of this application is described below.

The input/output interface 702 is configured to send a downlink data signal to a terminal device.

The input/output interface 702 is further configured to receive indication information from the terminal device.

For an operation performed by the logic circuit 701, refer to the description of the network device in the embodiment corresponding to FIG. 3.

A person skilled in the art may further understand that various illustrative logical blocks (illustrative logical blocks) and steps (steps) that are listed in embodiments of this application may be implemented by electronic hardware, computer software, or a combination thereof. Whether the functions are implemented by using hardware or software depends on particular applications and a design requirement of the entire system. A person skilled in the art may use various methods to implement the described functions for each particular application, but it should not be considered that the implementation goes beyond the scope of embodiments of this application.

This application further provides a computer-readable storage medium. The computer-readable storage medium stores a computer program. When the computer-readable storage medium is executed by a computer, the function of any one of the foregoing method embodiments is implemented.

This application further provides a computer program product. When the computer program product is executed by a computer, the function of any one of the foregoing method embodiments is implemented.

This application further provides a communication system. The communication system includes the communication apparatus shown in FIG. 4 and the communication apparatus shown in FIG. 5.

All or some of the foregoing embodiments may be implemented by software, hardware, firmware, or any combination thereof. When software is used to implement embodiments, all or some embodiments may be implemented in a form of a computer program product. The computer program product includes one or more computer instructions. When the computer program instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk, or a magnetic tape), an optical medium (for example, a high-density digital video disc (digital video disc, DVD)), a semiconductor medium (for example, a solid-state drive (solid-state drive, SSD)), or the like.

A person of ordinary skill in the art may understand that various numerical numbers such as "first" and "second" in this specification are merely used for differentiation for ease of description, and are not intended to limit the scope and sequence of embodiments of this application.

"Predefine" in this application may be understood as "define", "predefine", "store", "pre-store", "pre-negotiate", "pre-configure", "solidify", or "pre-burn".

A person of ordinary skill in the art may be aware that units and algorithm steps described with reference to embodiments disclosed in this specification can be implemented by electronic hardware, or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for convenient and brief description, for a detailed working process of the foregoing system, apparatus, and unit, refer to a corresponding process in the foregoing method embodiments. Details are not described herein again.

## Claims

1. A communication method, wherein the method comprises:

   receiving downlink data from a network device, wherein the downlink data corresponds to one or more code blocks CBs;
   determining, based on the downlink data, a decoded sequence obtained by performing channel decoding on the downlink data, wherein the decoded sequence is an estimation result of the CB, and one decoded sequence corresponds to one CB; and
   sending indication information to the network device, wherein the indication information indicates first information, the first information is determined based on a quantity of non-zero elements or a quantity of zero elements comprised in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB.

**2.** The method according to claim 1, wherein the first information is at least one of the following information: a quantity of non-zero elements comprised in first data corresponding to at least one of the one or more CBs, a proportion of a non-zero element comprised in first data corresponding to at least one of the one or more CBs, an average value of quantities of non-zero elements comprised in first data corresponding to at least one of the one or more CBs, a sum of quantities of non-zero elements comprised in first data corresponding to at least one of the one or more CBs, an average value of proportions of non-zero elements comprised in first data corresponding to at least one of the one or more CBs, a block error rate BLER corresponding to the at least one of the one or more CBs, or a BLER corresponding to a CB set comprising the plurality of CBs.

**3.** The method according to claim 1 or 2, wherein the first data is $A$, and $A = CH^T$, or $A = HC^T$.

**4.** The method according to claim 3, wherein the proportion of the non-zero element comprised in the first data is $\rho$, and $\rho = D(A)/(N - K)$, wherein $D(A)$ is the quantity of the non-zero elements comprised in the first data, $N$ is a length of an encoded sequence corresponding to the CB, and $K$ is a length of an unencoded sequence corresponding to the CB.

**5.** The method according to any one of claims 2 to 4, wherein there is a correspondence between the BLER corresponding to the CB and the quantity of the non-zero elements comprised in the first data corresponding to the CB, or there is a correspondence between the BLER corresponding to the CB and the proportion of the non-zero element comprised in the first data corresponding to the CB.

**6.** The method according to claim 2 or 3, wherein the first information is the proportion of the non-zero element comprised in the first data, and the proportion of the non-zero element is one or more of a plurality of preset proportions.

**7.** The method according to claim 6, wherein the plurality of preset proportions form an arithmetic sequence.

**8.** The method according to any one of claims 1 to 7, wherein the downlink data is coded by using linear block code.

**9.** The method according to any one of claims 1 to 8, wherein the indication information is carried in a hybrid automatic repeat request HARQ; or
the sending indication information to the network device comprises:
sending the indication information to the network device over a physical uplink control channel PUCCH or a physical uplink shared channel PUSCH.

**10.** A communication method, wherein the method comprises:

sending a downlink data signal to a terminal device, wherein the downlink data signal corresponds to one or more code blocks CBs; and
receiving indication information from the terminal device, wherein the indication information indicates first information, the first information is determined based on a quantity of non-zero elements comprised in first data, one piece of first data corresponds to one CB, the first data is related to $C$ and $H$, $C$ is a decoded sequence obtained by performing channel decoding on downlink data, and $H$ is a check matrix corresponding to the CB.

**11.** The method according to claim 10, wherein the first information is one of the following information: a quantity of non-zero elements comprised in first data corresponding to each of the one or more CBs, a proportion of a non-zero element comprised in first data corresponding to each of the one or more CBs, an average value of quantities of non-zero elements comprised in first data corresponding to each of the one or more CBs, or an average value of proportions of non-zero elements comprised in first data corresponding to each of the one or more CBs, and a block error rate BLER corresponding to the one or more CBs.

**12.** The method according to claim 10 or 11, wherein the first data is $A$, and $A = CH^T$, or $A = HC^T$.

**13.** The method according to claim 12, wherein the proportion of the non-zero element comprised in the first data is $\rho$, and $\rho = D(A)/(N - K)$, wherein $D(A)$ is the quantity of the non-zero elements, $N$ is a length of an encoded sequence corresponding to the CB, and $K$ is a length of an unencoded sequence corresponding to the CB.

**14.** The method according to any one of claims 11 to 13, wherein there is a correspondence between the BLER corresponding to the CB and the quantity of the non-zero elements comprised in the first data corresponding to the CB, or there is a correspondence between the BLER corresponding to the CB and the proportion of the non-zero element comprised in the first data corresponding to the CB.

15. The method according to claim 11 or 12, wherein the first information is the proportion of the non-zero element comprised in the first data, and the proportion of the non-zero element is one or more of a plurality of preset proportions.

16. The method according to claim 15, wherein the plurality of preset proportions form an arithmetic sequence.

17. The method according to any one of claims 10 to 16, wherein the downlink data is coded by using linear block code.

18. The method according to any one of claims 10 to 17, wherein the indication information is carried in a hybrid automatic repeat request HARQ sent by the terminal device; or
the receiving indication information from the terminal device comprises:
receiving the indication information from the terminal device over a physical uplink control channel PUCCH or a physical uplink shared channel PUSCH.

19. A communication apparatus, wherein the communication apparatus comprises a receiving module, a determining module, and a sending module;

the receiving module is configured to receive downlink data from a network device, wherein the downlink data corresponds to one or more code blocks CBs;
the determining module is configured to determine, based on the downlink data, a decoded sequence obtained by performing channel decoding on the downlink data, wherein the decoded sequence is an estimation result of the CB, and one decoded sequence corresponds to one CB; and
the sending module is configured to send indication information to the network device, wherein the indication information indicates first information, the first information is determined based on a quantity of non-zero elements or a quantity of zero elements comprised in first data, the first data is determined based on the decoded sequence, one piece of first data corresponds to one CB, the first data is related to $C$ and $H$, $C$ is the decoded sequence obtained by performing the channel decoding on the downlink data, and $H$ is a check matrix corresponding to the CB.

20. The communication apparatus according to claim 19, wherein the first information is at least one of the following information: a quantity of non-zero elements comprised in first data corresponding to at least one of the one or more CBs, a proportion of a non-zero element comprised in first data corresponding to at least one of the one or more CBs, an average value of quantities of non-zero elements comprised in first data corresponding to at least one of the one or more CBs, a sum of quantities of non-zero elements comprised in first data corresponding to at least one of the one or more CBs, an average value of proportions of non-zero elements comprised in first data corresponding to at least one of the one or more CBs, a block error rate BLER corresponding to the at least one of the one or more CBs, or a BLER corresponding to a CB set comprising the plurality of CBs.

21. The communication apparatus according to claim 19 or 20, wherein the first data is $A$, and $A = CH^T$, or $A = HC^T$.

22. The communication apparatus according to claim 21, wherein the proportion of the non-zero element comprised in the first data is P , and $\rho = D(A)/(N - K)$, wherein $D(A)$ is the quantity of the non-zero elements comprised in the first data, $N$ is a length of an encoded sequence corresponding to the CB, and $K$ is a length of an unencoded sequence corresponding to the CB.

23. The communication apparatus according to any one of claims 20 to 22, wherein there is a correspondence between the BLER corresponding to the CB and the quantity of the non-zero elements comprised in the first data corresponding to the CB, or there is a correspondence between the BLER corresponding to the CB and the proportion of the non-zero element comprised in the first data corresponding to the CB.

24. The communication apparatus according to claim 20 or 21, wherein the first information is the proportion of the non-zero element comprised in the first data, and the proportion of the non-zero element is one or more of a plurality of preset proportions.

25. The communication apparatus according to claim 24, wherein the plurality of preset proportions form an arithmetic sequence.

26. The communication apparatus according to any one of claims 19 to 25, wherein the downlink data is coded by using linear block code.

27. The communication apparatus according to any one of claims 19 to 26, wherein the indication information is carried in a hybrid automatic repeat request HARQ;
the sending module is further configured to:
send the indication information to the network device over a physical uplink control channel PUCCH or a physical uplink shared channel PUSCH.

28. A communication apparatus, wherein the communication apparatus comprises a sending module and a receiving module;

the sending module is configured to send a downlink data signal to a terminal device, wherein the downlink data signal corresponds to one or more code blocks CBs; and
the receiving module is configured to receive indication information from the terminal device, wherein the indication information indicates first information, the first information is determined based on a quantity of non-zero elements comprised in first data, one piece of first data corresponds to one CB, the first data is $\overline{c}H^{T}$, the first data is related to $C$ and $H$, $C$ is a decoded sequence obtained by performing channel decoding on downlink data, and $H$ is a check matrix corresponding to the CB.

29. The communication apparatus according to claim 28, wherein the first information is one of the following information: a quantity of non-zero elements comprised in first data corresponding to each of the one or more CBs, a proportion of a non-zero element comprised in first data corresponding to each of the one or more CBs, an average value of quantities of non-zero elements comprised in first data corresponding to each of the one or more CBs, or an average value of proportions of non-zero elements comprised in first data corresponding to each of the one or more CBs, and a block error rate BLER corresponding to the one or more CBs.

30. The communication apparatus according to claim 29, wherein the first data is $A$, and $A = CH^{T}$, or $A = HC^{T}$.

31. The communication apparatus according to claim 30, wherein the proportion of the non-zero element comprised in the first data is $\rho$, and $\rho = D(A)/(N - K)$, wherein $D(A)$ is the quantity of the non-zero elements, $N$ is a length of an encoded sequence corresponding to the CB, and $K$ is a length of an unencoded sequence corresponding to the CB.

32. The communication apparatus according to any one of claims 29 to 31, wherein there is a correspondence between the BLER corresponding to the CB and the quantity of the non-zero elements comprised in the first data corresponding to the CB, or there is a correspondence between the BLER corresponding to the CB and the proportion of the non-zero element comprised in the first data corresponding to the CB.

33. The communication apparatus according to claim 29 or 30, wherein the first information is the proportion of the non-zero element comprised in the first data, and the proportion of the non-zero element is one or more of a plurality of preset proportions.

34. The communication apparatus according to claim 33, wherein the plurality of preset proportions form an arithmetic sequence.

35. The communication apparatus according to any one of claims 28 to 34, wherein the downlink data is coded by using linear block code.

36. The communication apparatus according to any one of claims 28 to 35, wherein the indication information is carried in a hybrid automatic repeat request HARQ sent by the terminal device; or
the receiving module is further configured to:
receive the indication information from the terminal device over a physical uplink control channel PUCCH or a physical uplink shared channel PUSCH.

37. A communication apparatus, comprising a processor, wherein
the processor is configured to invoke program code or instructions stored in a memory, to enable the communication apparatus to perform the method according to any one of claims 1 to 18.

38. A communication apparatus, wherein the communication apparatus comprises a logic circuit and an input/output interface;

the input/output interface is configured to input a downlink data signal from a network device;
the input/output interface is further configured to output indication information to the network device; and
the logic circuit is configured to: process the downlink data signal, and perform the method according to any one of claims 1 to 9.

39. A communication apparatus, wherein the communication apparatus comprises a logic circuit and an input/output interface;

the input/output interface is configured to send a downlink data signal to a terminal device;
the input/output interface is further configured to receive indication information from the terminal device; and
the logic circuit is configured to perform the method according to any one of claims 10 to 18.

40. A computer-readable storage medium, wherein the computer-readable storage medium is configured to store instructions, and when the instructions are executed, the method according to any one of claims 1 to 18 is implemented.

41. A computer program product, wherein the computer program product comprises a computer program or instructions, and when the computer program or the instructions are run on a computer, the computer is enabled to perform the method according to any one of claims 1 to 18.

42. A communication system, wherein the communication system comprises the communication apparatus according to any one of claims 19 to 27 and the communication apparatus according to any one of claims 28 to 36.

FIG. 1

FIG. 2

Network device | Terminal device

S101: Send downlink data →

S102: Determine, based on the downlink data, a decoded sequence obtained by performing channel decoding on the downlink data

← S103: Send indication information, where the indication information indicates first information, the first information is determined based on a quantity of non-zero elements or a quantity of zero elements included in first data, and the first data is determined based on the decoded sequence

FIG. 3

Communication apparatus 40

Receiving module — 401

Determining module — 402

Sending module — 403

FIG. 4

Communication apparatus 50

Sending module — 501

Receiving module — 502

FIG. 5

Processor — 601

Memory — 602

Program code — 603

Transceiver — 604

Communication apparatus 60

FIG. 6

Logic circuit — 701

Chip

70

Input/Output interface — 702

FIG. 7

| INTERNATIONAL SEARCH REPORT | International application No. |
|---|---|
| | **PCT/CN2022/138463** |

| **A.** | **CLASSIFICATION OF SUBJECT MATTER** |
|---|---|

H04W28/02(2009.01)i

According to International Patent Classification (IPC) or to both national classification and IPC

| **B.** | **FIELDS SEARCHED** |
|---|---|

Minimum documentation searched (classification system followed by classification symbols)

IPC:H04W,H04Q,H04L

Documentation searched other than minimum documentation to the extent that such documents are included in the fields searched

Electronic data base consulted during the international search (name of data base and, where practicable, search terms used)

CJFD, CNABS, CNTXT, DWPI, ENTXT, ENTXTC, WPABS, WPABSC: 信道质量指示, 比特块, 编码块, 传输块, 非零元素, 零元素, 下行, 校验, 校验序列, 解码, 译码, 译码序列, CQI, CB, coded block, TB, zero, non-zero, downlink, CRC, verify, check, decode, sequence

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| A | CN 110474725 A (HUAWEI TECHNOLOGIES CO., LTD.) 19 November 2019 (2019-11-19) description, paragraphs [0057]-[0218] | 1-42 |
| A | CN 108242972 A (HUAWEI TECHNOLOGIES CO., LTD.) 03 July 2018 (2018-07-03) entire document | 1-42 |
| A | WO 2016067318 A1 (NEC CORP.) 06 May 2016 (2016-05-06) entire document | 1-42 |
| A | WO 2016164058 A1 (NTT DOCOMO INC;KAKISHIMA YUICHI;NAGATA SATOSHI;NA CHONGNING;HOU XIAOLIN;JIANG HUILING;) 13 October 2016 (2016-10-13) entire document | 1-42 |
| A | US 2011170642 A1 (NOKIA CORP.) 14 July 2011 (2011-07-14) entire document | 1-42 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 February 2023** | **10 February 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
**Information on patent family members**

International application No.

**PCT/CN2022/138463**

| Patent document cited in search report | | | Publication date (day/month/year) | Patent family member(s) | | | Publication date (day/month/year) |
|---|---|---|---|---|---|---|---|
| CN | 110474725 | A | 19 November 2019 | WO | 2019214427 | A1 | 14 November 2019 |
| CN | 108242972 | A | 03 July 2018 | EP | 3550747 | A1 | 09 October 2019 |
| | | | | EP | 3550747 | A4 | 27 November 2019 |
| | | | | WO | 2018121460 | A1 | 05 July 2018 |
| | | | | JP | 2020503758 | A | 30 January 2020 |
| | | | | US | 2019319743 | A1 | 17 October 2019 |
| | | | | US | 10924211 | B2 | 16 February 2021 |
| WO | 2016067318 | A1 | 06 May 2016 | US | 2017244513 | A1 | 24 August 2017 |
| | | | | US | 10263730 | B2 | 16 April 2019 |
| | | | | JP | 2017539184 | A | 28 December 2017 |
| | | | | JP | 6380683 | B2 | 29 August 2018 |
| WO | 2016164058 | A1 | 13 October 2016 | US | 2018091207 | A1 | 29 March 2018 |
| | | | | US | 10256886 | B2 | 09 April 2019 |
| | | | | EP | 3281302 | A1 | 14 February 2018 |
| | | | | JP | 2018511271 | A | 19 April 2018 |
| | | | | JP | 6594443 | B2 | 23 October 2019 |
| US | 2011170642 | A1 | 14 July 2011 | US | 8437437 | B2 | 07 May 2013 |
| | | | | WO | 2010031893 | A1 | 25 March 2010 |

Form PCT/ISA/210 (patent family annex) (July 2022)

**EP 4 447 536 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111679685